(19) Europäisches Patentamt
European Patent Office
Office européen des brevets

(11) EP 3 096 436 A1

(12) EUROPEAN PATENT APPLICATION
published in accordance with Art. 153(4) EPC

(43) Date of publication:
23.11.2016 Bulletin 2016/47

(51) Int Cl.:
H02J 50/00 (2016.01)   H02J 7/00 (2006.01)

(21) Application number: 15733244.6

(22) Date of filing: 06.01.2015

(86) International application number:
PCT/JP2015/050141

(87) International publication number:
WO 2015/102113 (09.07.2015 Gazette 2015/27)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 06.01.2014 JP 2014000458
22.05.2014 JP 2014106357

(71) Applicant: Nitto Denko Corporation
Ibaraki-shi, Osaka 567-8680 (JP)

(72) Inventors:
• TSUDA, Hisashi
  Ibaraki-shi
  Osaka 567-8680 (JP)
• HATANAKA, Takezo
  Ibaraki-shi
  Osaka 567-8680 (JP)
• VU, Nam Tung
  Ibaraki-shi
  Osaka 567-8680 (JP)

(74) Representative: Müller-Boré & Partner
Patentanwälte PartG mbB
Friedenheimer Brücke 21
80639 München (DE)

(54) WIRELESS POWER TRANSMISSION DEVICE

(57) There is provided a wireless power transmission apparatus including: a power-supplying module configured to supply power to a power-receiving module by means of a resonance phenomenon which is established between the power-supplying module and the power-receiving module so that a magnetic field space having a lower magnetic field strength than that of nearby portions is formed; a magnetic field detector which is disposed at a position where the magnetic field space is formed and which is configured to detect the magnetic field strength; and a determination control device configured to determine whether there is an anomaly in power supply to the power-receiving module based on a value of the magnetic field strength detected by the magnetic field detector.

FIG2.

**Description**

Technical Field

The present invention relates to a wireless power transmission apparatus configured to supply power from a power-supplying module to a power-receiving module utilizing a resonance phenomenon.

Background Art

Portable electronic devices such as laptop PCs, tablet PCs, digital cameras, mobile phones, portable gaming devices, earphone-type music players, wireless headsets, hearing aids, recorders, which are portable while being used by the user have rapidly increased in recent years. Many of these portable electronic devices have therein a rechargeable battery, which requires periodical charging. To facilitate the work for charging the rechargeable battery of such an electronic device, there are an increasing number of devices for charging rechargeable batteries by using a power-supplying technology that performs wireless power transmission between a power-supplying module and a power-receiving module mounted in the electronic device (wireless power transmission technology performing power transmission by varying the magnetic field).

As a wireless power transmission technology, there have been known, for example, a technology that performs power transmission by means of electromagnetic induction between coils (e.g. see Patent Literature 1), a technology that performs power transmission by coupling magnetic fields by means of a resonance phenomenon (magnetic field resonant state) between resonators (coils) provided to the power-supplying device (power-supplying module) and the power-receiving device (power-receiving module)(e.g. see Patent Literature 2).

For example, to perform wireless power transmission by coupling magnetic fields utilizing resonance phenomenon (magnetic field resonant state) between the resonators (coils) of the power-supplying module and the power-receiving module, the power-receiving module needs to be brought close to the power-supplying module so that they are within a distance (power-suppliable region) that enables power supply from the power-supplying module to the power-receiving module. If, during such usage, a metal foreign object is placed in the vicinity of the power-supplying module, the metal foreign object is influenced by the magnetic field, and an eddy current is induced. If an eddy current is induced, excessive heat may occur in the metal foreign object and/or the power-supplying module.

A suggested measure to address this issue is to provide a detector (sensor and the like) to the power-supplying module or the power-receiving module to detect various changes caused by arranging the power-supplying module and the power-receiving module within the power-suppliable region, and to determine whether there is a metal foreign object in the vicinity of the power-supplying module based on a detection result from the detector.

For example, Patent Literature 3 describes that a detector (current/voltage detector 113) is provided to a power-supplying device (power-supplying module) of a power-supplying system, an impedance is obtained based on the value of current/voltage measured by the detector, and variation in this impedance (an amount of increase in the impedance and the like: see paragraph [0048] and the like) is compared with a pre-set threshold value to determine whether there is a foreign object (metal foreign object).

Citation List

Patent Literature

Patent Literature 1: Japanese patent No. 4624768
Patent Literature 2: Japanese Unexamined Paten Publication No. 239692/2013
Patent Literature 3: Japanese Unexamined Paten Publication No. 62895/2013

Summary of Invention

Technical Problem

However, there is a possibility that the variation in impedance is not explicitly observed depending on the type or size of the foreign object (metal foreign object).

Thus, in the present invention, attention is paid to a magnetic field space which has a lower magnetic field strength than that of nearby portions and which is formed by a resonance phenomenon occurring between a power-supplying module and the power-receiving module during power supply, and there is provided a wireless power transmission apparatus capable of determining whether there is an anomaly in power supply by detecting a magnetic field strength in a space where the above magnetic field space is formed.

Solution to Problem

According to an aspect of the invention to solve the above problem, there is provided a wireless power transmission apparatus including: a power-supplying module configured to supply power to a power-receiving module by means of a resonance phenomenon which is established between the power-supplying module and the power-receiving module so that a magnetic field space having a lower magnetic field strength than that of nearby portions is formed; a magnetic field detector which is disposed at a position where the magnetic field space is formed and which is configured to detect the magnetic field strength; and a determination control device configured to determine whether there is an anomaly in power supply to the power-receiving module based on a value of the magnetic field strength detected by the magnetic field detector.

With the above structure, a magnetic field generated around the power-supplying module and a magnetic field generated around the power-receiving module cancel each other out when power is supplied from the power-supplying module to the power-receiving module utilizing the resonance phenomenon, and thereby the magnetic field space having a lower magnetic field strength than that of nearby portions is formed in the vicinity of the power-supplying module and the power-receiving module. The magnetic field strength of the magnetic field is detected using the magnetic field detector disposed in the magnetic field space, and based on the value of the detected magnetic field strength, an anomaly in power supply is detected. Thus, it is possible to achieve safe power supply while preventing an increase in size of the wireless power transmission apparatus.

According to another aspect of the invention, the wireless power transmission apparatus is arranged so that the determination control device is configured to stop power supply to the power-supplying module when determining that there is an anomaly in the power supply.

With the above structure, when an anomaly in power supply is detected, power supply to the power-supplying module is stopped, and thereby occurrence of malfunction due to abnormal power supply is prevented.

According to another aspect of the invention, the wireless power transmission apparatus further includes a reporting device configured to give a report to an outside, and is arranged so that when the determination control device determines that there is an anomaly in the power supply, the determination control device controls the reporting device to report the anomaly in the power supply.

With the above structure, when an anomaly in power supply is detected, the anomaly is reported to the outside using the reporting device.

According to another aspect of the invention, the wireless power transmission apparatus is arranged so that: the power-supplying module and the power-receiving module respectively include at least a power-supplying resonator and a power-receiving resonator which resonate with each other at a predetermined resonance frequency; and a power-source frequency of a power source is set to a frequency higher than the resonance frequency so that current in the power-supplying resonator and current in the power-receiving resonator flow in directions opposite to each other during power supply by means of the resonance phenomenon from the power-supplying resonator to the power-receiving resonator.

In the above-described structure, the coupling coefficient indicating the strength of coupling between the power-supplying resonator and the power-receiving resonator is increased when the magnetic field space having a lower magnetic field strength than that of nearby portions is formed. When a transmission characteristic "S21" (which is an index of the power transmission efficiency in the power transmission from the power-supplying module to the power-receiving module) is analyzed while the coupling coefficient is high as above, the analyzed waveform of the transmission characteristic "S21" has separate peaks; one on the low frequency side and another on the high frequency side. By setting a power-source frequency of the power source to the frequency on the high frequency side, the current in the power-supplying resonator and the current in the power-receiving resonator flow in directions opposite to each other. With this, as the magnetic field generated on the inner circumference side of the power-supplying module (inside with respect to a radial direction of the module) and the magnetic field generated on the inner circumference side of the power-receiving module cancel each other out, the influence of the magnetic fields is reduced, and thereby the magnetic field space having a lower magnetic field strength than that of nearby portions is formed on the inner circumference side of the power-supplying resonator. Further, the magnetic field detector is disposed on the inner circumference side of the power-supplying resonator where the magnetic field space is formed, and thereby, the space on the inner circumference side of the power-supplying resonator is effectively utilized, leading to downsizing of the wireless power transmission apparatus.

According to another aspect of the invention, the wireless power transmission apparatus is arranged so that: the power-supplying module and the power-receiving module respectively include at least a power-supplying resonator and a power-receiving resonator which resonate with each other at a predetermined resonance frequency; and a power-source frequency of a power source is set to a frequency lower than the resonance frequency so that current in the power-supplying resonator and current in the power-receiving resonator flow in a same direction during power supply by means of the resonance phenomenon from the power-supplying resonator to the power-receiving resonator.

In the above-described structure, the coupling coefficient indicating the strength of coupling between the power-supplying resonator and the power-receiving resonator is increased when the magnetic field space having a lower magnetic field strength than that of nearby portions is formed. When the transmission characteristic "S21" (which is an index of the power transmission efficiency in the power transmission from the power-supplying module to the power-receiving module) is analyzed while the coupling coefficient is high as above, the analyzed waveform of the transmission characteristic "S21" has separate peaks; one on the low frequency side and another on the high frequency side. By setting a power-source frequency of the power source to the frequency on the low frequency side, the current in the power-supplying resonator and the current in the power-receiving resonator flow in the same direction. With this, as the magnetic field generated on the outer circumference side of the power-supplying module and the magnetic field generated on the outer circumference side of the power-receiving module cancel each other out, the influence of the magnetic fields is reduced, and thereby the magnetic field space having a lower magnetic field strength than that of nearby portions is formed on the outer circumference side of the power-supplying resonator. Further, the magnetic field detector is disposed on the outer circumference side of the power-supplying resonator where the magnetic field space is formed, and thereby, the space on the outer circumference side of the power-supplying resonator is effectively utilized, leading to downsizing of the wireless power transmission apparatus.

According to another aspect of the invention, the wireless power transmission apparatus is arranged so that the magnetic field detector is a Hall-effect magnetic sensor.

In the above structure, the Hall-effect magnetic sensor is used as the magnetic field detector. This makes it possible to detect the magnetic field strength with high accuracy and to downsize the wireless power transmission apparatus because the Hall-effect magnetic sensor is small in size.

According to another aspect of the invention, the wireless power transmission apparatus is arranged so that the magnetic field detector is a coil.

In the above structure, the coil is used as the magnetic field detector, and thereby the production cost of the wireless power transmission apparatus is reduced. It is possible to change the size of the coil (such as the diameter, thickness, number of turns, and wire diameter of the coil) to some extent. This enables the size of the coil to be adjusted depending on the size of and/or the space in the wireless power transmission apparatus.

According to another aspect of the invention, the wireless power transmission apparatus is arranged so that: the power-supplying resonator includes a coil; and
the magnetic field detector is disposed between a central axis of the coil and an inner circumferential surface of the coil, and closer to the inner circumferential surface of the coil rather than the central axis of the coil.

With the above structure, the sensitivity to detect the magnetic field strength is enhanced by disposing the magnetic field detector closer to the inner circumferential surface of the coil of the power-supplying resonator rather than the coil central axis of the power-supplying resonator, as compared with the case where the magnetic field detector is disposed at a position along the coil central axis of the power-supplying resonator.

According to another aspect of the invention, the wireless power transmission apparatus is arranged so that the magnetic field detector is disposed at a position along the inner circumferential surface of the coil.

With the above structure, the sensitivity to detect the magnetic field strength is further enhanced by disposing the magnetic field detector at a position along the inner circumferential surface of the coil of the power-supplying resonator.

According to another aspect of the invention, the wireless power transmission apparatus is arranged so that: each of the power-supplying resonator and the power-receiving resonator includes a coil; and
the magnetic field detector is disposed on an inner circumference side of the coil of power-supplying resonator, and closer to a facing portion of the coil of the power-supplying resonator which faces the coil of the power-receiving resonator than the other portion of the coil of the power-supplying resonator which does not face the coil of the power-receiving resonator.

With the above structure, the sensitivity to detect the magnetic field strength is further enhanced by disposing the magnetic field detector on the inner circumference side of the coil of the power-supplying resonator, and closer to the facing portion of the coil of the power-supplying resonator which faces the coil of the power-receiving resonator than the other portion thereof which does not face the coil of the power-receiving resonator, as compared with the case where the magnetic field detector is disposed closer to the other portion which does not face the coil of the power-receiving resonator.

According to another aspect of the invention, the wireless power transmission apparatus is arranged so that the magnetic field detector is disposed at a position on a plane defined by the facing portion of the coil of the power-supplying resonator which faces the coil of the power-receiving resonator.

With the above structure, the sensitivity to detect the magnetic field strength is further enhanced by disposing the magnetic field detector at a position on the plane defined by the facing portion of the coil of the power-supplying resonator which faces the coil of the power-receiving resonator.

According to another aspect of the invention, the wireless power transmission apparatus is arranged so that:
the power-supplying resonator includes a coil;
the magnetic field detector is a Hall-effect magnetic sensor configured to detect the magnetic field strength by using Hall effect to a thin plate-like semiconductor included therein; and
the Hall-effect magnetic sensor is disposed so that the thin plate-like semiconductor is oriented orthogonal to a direction of the central axis of the coil of the power-supplying resonator, on an inner circumference side of the coil of the power-supplying resonator.

With the above structure, the sensitivity to detect the magnetic field strength is enhanced by disposing the Hall-effect magnetic sensor so that the thin plate-like semiconductor is oriented orthogonal to the direction of the central axis of the coil of the power-supplying resonator, on the inner circumference side of the coil of the power-supplying resonator.

Advantageous Effects of Invention

Paying attention to a magnetic field space which has a lower magnetic field strength than that of nearby portions and which is formed by a resonance phenomenon occurring between a power-supplying module and the power-receiving module during power supply, there is provided a wireless power transmission apparatus capable of determining whether there is an anomaly in power supply by detecting a magnetic field strength in a space where the above magnetic field space is formed.

Brief Description of Drawings

[FIG. 1] FIG.1 is an explanatory diagram of a charger having a power-supplying module mounted therein and a wireless headset having a power-receiving module mounted therein.
[FIG. 2] FIG. 2 is a block diagram of a wireless power transmission apparatus.
[FIG. 3] FIG. 3 is an explanatory diagram illustrating the wireless power transmission apparatus, in the form of an equivalent circuit.
[FIG. 4] FIG. 4 is an explanatory diagram illustrating a case where a transmission characteristic S21 between resonators has two peaks.
[FIG. 5] FIG. 5 is an explanatory diagram of the wireless power transmission apparatus connected to a network analyzer.
[FIG. 6] FIG. 6 is a magnetic field vector diagram in an antiphase resonance mode.
[FIG. 7] FIG. 7 is a magnetic field vector diagram in an inphase resonance mode.
[FIG. 8] FIG. 8 is an explanatory diagram illustrating a state where normal charging is performed between the power-supplying module and the power-receiving module (normal charging state) .
[FIG. 9] FIG. 9 is an explanatory diagram illustrating the charger in a standby state.
[FIG. 10] FIG. 10 is an explanatory diagram illustrating a state where a metal foreign object is placed in the vicinity of the charger (abnormal state).
[FIG. 11] FIG. 11 is a block diagram of the wireless power transmission apparatus (in the normal charging state) used in measurement experiments.
[FIG. 12] FIG. 12 is a block diagram of the wireless power transmission apparatus (in the standby state) used in the measurement experiments.
[FIG. 13] FIG. 13 is a block diagram of the wireless power transmission apparatus (in the abnormal state) used in the measurement experiments.
[FIG. 14] FIG. 14 is an explanatory diagram of detection voltages detected by a Hall-effect magnetic sensor.
[FIG. 15] FIG. 15 is a table showing measurement results of Measurement Experiment 1.
[FIG. 16] FIG. 16 is an explanatory diagram of detection voltages detected by a magnetism detecting coil.
[FIG. 17] FIG. 17 is a table showing measurement results of Measurement Experiment 2.
[FIG. 18] FIG. 18 is a flowchart describing a power-supply operation flow executed by a determination control device.
[FIG. 19] FIG. 19 is an explanatory diagram of the wireless power transmission apparatus (in the standby state) used in Measurement Experiments 4 and 5.
[FIG. 20] FIG. 20 is an explanatory diagram of the wireless power transmission apparatus (in the normal charging state) used in Measurement Experiments 4 and 5.
[FIG. 21] FIG. 21 is an explanatory diagram of the wireless power transmission apparatus (in the abnormal state) used in Measurement Experiments 4 and 5.
[FIG. 22] FIG. 22 is an explanatory diagram illustrating positions where the Hall-effect magnetic sensor is disposed.

[FIG. 23] FIG. 23 is an explanatory diagram illustrating upright and flat orientations of the Hall-effect magnetic sensor.
[FIG. 24] FIG. 24 is a graphical representation showing measurement results of Measurement Experiment 3.
[FIG. 25] FIG. 25 is a graphical representation showing measurement results of Measurement Experiment 3.
[FIG. 26] FIG. 26 is a graphical representation showing measurement results of Measurement Experiment 3.
[FIG. 27] FIG. 27 is a graphical representation showing measurement results of Measurement Experiment 4.

Description of Embodiments

The following describes a wireless power transmission apparatus 1 of the present invention, which is used for wireless power transmission.

(Embodiment)

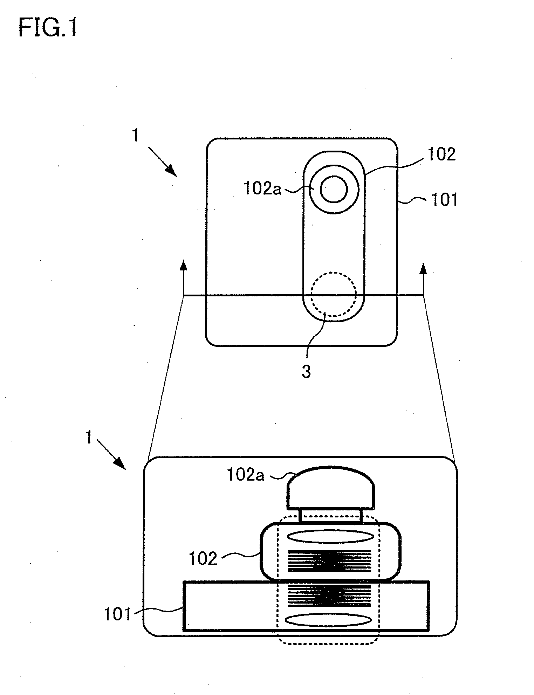

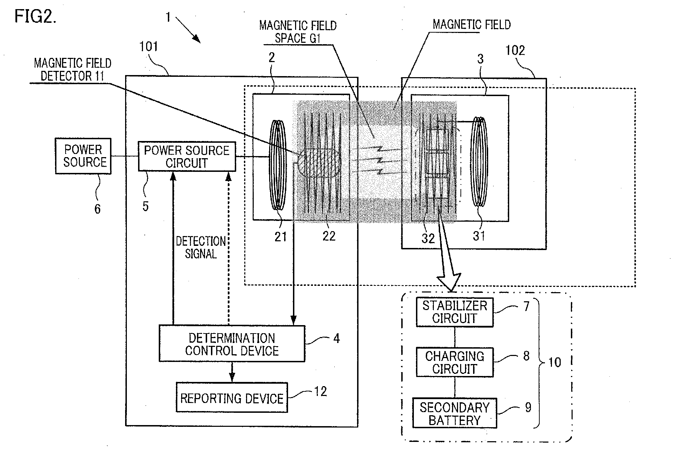

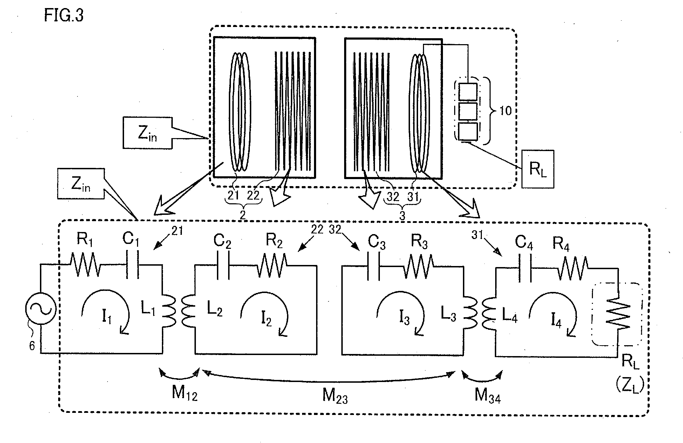

The wireless power transmission apparatus 1 is configured to form a magnetic field space G1 (G2) having a lower magnetic field strength than that of nearby portions, and the apparatus 1 includes, as essential components, a power-supplying module 2 including a power-supplying resonator 22, and a power-receiving module 3 including a power-receiving resonator 32. In this embodiment, a charger 101 having the power-supplying module 2 mounted therein and a wireless headset 102 having the power-receiving module 3 mounted therein will be described, as an example of the wireless power transmission apparatus 1. FIG. 1 illustrates the charger 101 and the wireless headset 102 at the time of charging. FIG. 2 is a block diagram illustrating the structure of the wireless power transmission apparatus 1. FIG. 3 is an explanatory diagram illustrating the power-supplying module 2 and the power-receiving module 3, in the form of an equivalent circuit.

(Structures of Charger 101 and Wireless Headset 102)

As shown in FIG. 1 and FIG. 2, the charger 101 includes the power-supplying module 2 having a power-supplying coil 21 and the power-supplying resonator 22. The wireless headset 102 includes: an earphone speaker unit 102a; and the power-receiving module 3 having a power-receiving coil 31 and the power-receiving resonator 32.

The power-supplying coil 21 of the power-supplying module 2 is connected to a power source circuit 5 structured by an oscillation circuit (e.g. , an inverter circuit) and the like. The oscillation circuit is configured to set a power-source frequency of the power to be supplied from an outside power source 6 to the power-supplying module 2 to a predetermined value. On an inner circumference side of the power-supplying resonator 22, disposed is a magnetic field detector 11 configured to detect a magnetic field strength. The magnetic field detector 11 is connected to a determination control device 4. The determination control device 4 is connected to the power source circuit 5. The determination control device 4 is also connected to a reporting device 12.

The power-receiving coil 31 of the power-receiving module 3 is connected to a secondary battery 9 via a stabilizer circuit 7 configured to rectify AC power received and a charging circuit 8 configured to prevent overcharge. As shown in FIG. 2, the stabilizer circuit 7, the charging circuit 8, and the secondary battery 9 are disposed on the inner circumference side of the power-receiving resonator 32, where the later-described magnetic field space G1 is formed. Further, as shown in FIG. 1 and FIG. 2, the stabilizer circuit 7, the charging circuit 8, and the secondary battery 9 of the present embodiment constitute a power-supplied device 10 which is the final destination of the supplied power. The power-supplied device 10 is used to collectively indicate the devices of the final destination to which the power-receiving module 3 is connected. A set of the power-supplying module 2 and the power-receiving module 3 is the wireless power transmission apparatus 1.

The charger 101 has a not-shown accommodation groove for accommodating the wireless headset 102, which has a shape corresponding to the shape of the wireless headset 102. When the wireless headset 102 is accommodated in the accommodation groove of the charger 101, the wireless headset 102 is positioned in such a manner that the power-supplying module 2 of the charger 101 and the power-receiving module 3 of the wireless headset 102 face each other.

The power-supplying coil 21 plays a role of supplying power obtained from the power source 6 via the power source circuit 5, to the power-supplying resonator 22 by means of electromagnetic induction. As shown in FIG. 3, the power-supplying coil 21 is constituted by an RLC circuit whose elements include a resistor $R_1$, a coil $L_1$, and a capacitor $C_1$. As the coil $L_1$, a solenoid coil is used. The total impedance of a circuit element constituting the power-supplying coil 21 is $Z_1$. In the present embodiment, the $Z_1$ is the total impedance of the RLC circuit (circuit element) constituting the power-supplying coil 21, which includes the resistor $R_1$, the coil $L_1$, and the capacitor $C_1$. Further, the current that flows in the power-supplying coil 21 is $I_1$.

The power-receiving coil 31 plays roles of receiving the power having been transmitted as a magnetic field energy from the power-supplying resonator 22 to the power-receiving resonator 32, by means of electromagnetic induction, and supplying the power received to the secondary battery 9 via the stabilizer circuit 7 and the charging circuit 8. As shown in FIG. 3, the power-receiving coil 31, similarly to the power-supplying coil 21, is constituted by an RLC circuit whose elements include a resistor $R_4$, a coil $L_4$, and a capacitor $C_4$. As the coil $L_4$, a solenoid coil is used. The total impedance of a circuit element constituting the power-receiving coil 31 is $Z_4$. In the present embodiment, the $Z_4$ is the total impedance of the RLC circuit (circuit element) constituting the power-receiving coil 31, which includes the resistor $R_4$, the coil $L_4$, and the capacitor $C_4$. The total impedance of the power-supplied device 10 (the stabilizer circuit 7, the charging circuit 8, and the secondary battery 9) connected to the power-receiving coil 31 is $Z_L$. Further, the current that flows in the power-receiving coil 31 is $I_4$. However, as shown in FIG. 3, the total load impedance of the power-supplied device 10 (the stabilizer circuit 7, the charging circuit 8, and the secondary battery 9) connected to the power-receiving coil 31 is implemented in the form of a resistor $R_L$ (corresponding to $Z_L$) for the sake of convenience.

As shown in FIG. 3, the power-supplying resonator 22 is constituted by an RLC circuit whose elements include a resistor $R_2$, a coil $L_2$, and a capacitor $C_2$. Further, as shown in FIG. 3, the power-receiving resonator 32 is constituted by an RLC circuit whose elements include a resistor $R_3$, a coil $L_3$, and a capacitor $C_3$. The power-supplying resonator 22 and the power-receiving resonator 32 each serves as a resonance circuit and plays a role of creating a magnetic field resonant state. The magnetic field resonant state (resonance phenomenon) here is a phenomenon in which two or more coils resonate with each other in a resonance frequency band. The total impedance of a circuit element constituting the power-supplying resonator 22 is $Z_2$. In the present embodiment, the $Z_2$ is the total impedance of the RLC circuit (circuit element) constituting the power-supplying resonator 22, which includes the resistor $R_2$, the coil $L_2$, and the capacitor $C_2$. The total impedance of a circuit element constituting the power-receiving resonator 32 is $Z_3$. In the present embodiment, the $Z_3$ is the total impedance of the RLC circuit (circuit element) constituting the power-receiving resonator 32, which includes the resistor $R_3$, the coil $L_3$, and the capacitor $C_3$. Further, the current that flows in the power-supplying resonator 22 is $I_2$, and the current that flows in the power-receiving resonator 32 is $I_3$.

In the RLC circuit which is the resonance circuit in each of the power-supplying resonator 22 and the power-receiving resonator 32, the resonance frequency is f0 which is derived from (Formula 1) below, where the inductance is L and the capacity of capacitor is C.

[Equation 1]

$$f = \frac{1}{2\pi\sqrt{LC}} \quad \dots \dots \text{ (Formula 1)}$$

As each of the power-supplying resonator 22 and the power-receiving resonator 32, a solenoid coil is used. The resonance frequency of the power-supplying resonator 22 and that of the power-receiving resonator 32 are matched with each other. Each of the power-supplying resonator 22 and the power-receiving resonator 32 maybe a spiral coil or a solenoid coil as long as it is a resonator using a coil.

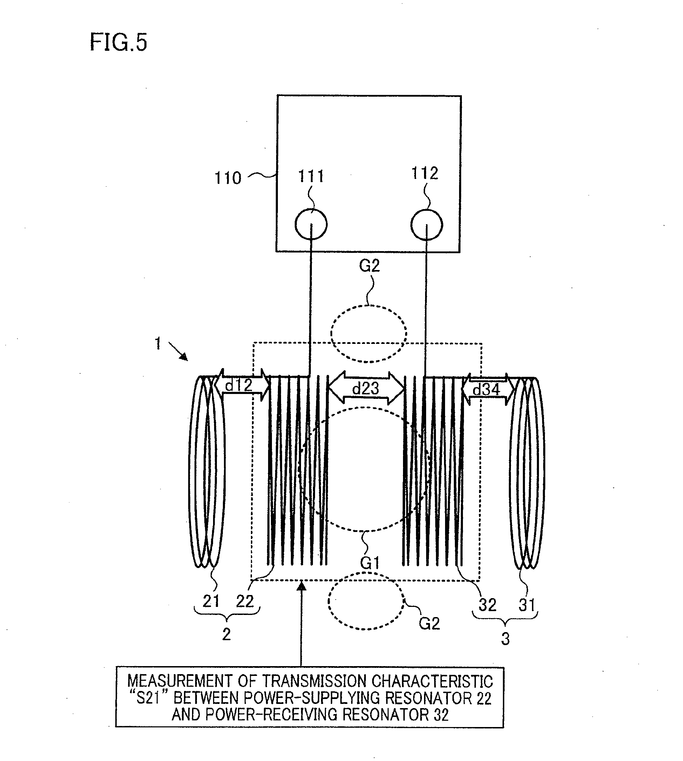

The distance between the power-supplying coil 21 and the power-supplying resonator 22 is d12, the distance between the power-supplying resonator 22 and the power-receiving resonator 32 is d23, and the distance between the power-receiving resonator 32 and the power-receiving coil 31 is d34 (see FIG. 5) .

Further, as shown in FIG. 3, the mutual inductance between the coil $L_1$ of the power-supplying coil 21 and the coil $L_2$ of the power-supplying resonator 22 is $M_{12}$, the mutual inductance between the coil $L_2$ of the power-supplying resonator 22 and the coil $L_3$ of the power-receiving resonator 32 is $M_{23}$, and the mutual inductance between the coil $L_3$ of the power-receiving resonator 32 and the coil $L_4$ of the power-receiving coil 31 is $M_{34}$. Further, in the power-supplying module 2 and the power-receiving module 3, a coupling coefficient between the coil $L_1$ and the coil $L_2$ is denoted as $K_{12}$, a coupling coefficient between the coil $L_2$ and the coil $L_3$ is denoted as $K_{23}$, and a coupling coefficient between the coil $L_3$ and the coil $L_4$ is denoted as $K_{34}$.

In the present embodiment, the magnetic field detector 11 is disposed on the inner circumference side of the power-supplying resonator 22, for which the solenoid coil is used, of the power-supplying module 2. This is where the later-described magnetic field space G1 is formed. As the magnetic field detector 11, a Hall-effect magnetic sensor is used. A change in measured voltage can be regarded as a change in the magnetic field strength (because the measured voltage is proportional to the magnetic field strength) . As the magnetic field detector 11, a coil (e.g., a solenoid coil) may be used.

The determination control device 4 is structured by, for example, a microcomputer, a storage device, and the like. The determination control device 4 has a function of determining whether there is an anomaly in power supply to the power-receiving module based on the value of the voltage detected by the magnetic field detector 11. Then, the determination control device 4 controls the power source circuit 5 so as to stop the power supply to the power-supplying module 2 when determining that there is an anomaly in the power supply. To be more specific, when determining that there is an anomaly in the power supply, the determination control device 4 transmits a control signal to control the power source circuit 5, thereby to stop the power supply to the power-supplying module 2.

Further, the determination control device 4 transmits a detection signal to the power source circuit 5 after a predetermined time interval (this predetermined time interval is freely settable). Upon reception of the detection signal, the power source circuit 5 temporarily supplies power to the power-supplying module 2, for a short time. With this, power is temporarily supplied to the power-supplying module 2, to create a magnetic field in the vicinity of the power-supplying resonator 22, which enables the magnetic field detector 11 to detect the magnetic field strength.

The reporting device 12 is not limited as long as it is configured to report the state of the wireless power transmission apparatus 1 to the outside. Examples of the reporting device 12 include an alarm, an LED lamp, a display, and the like. When the determination control device 4 determines that there is an anomaly in the power supply, the anomaly in the power supply is reported to the outside by the reporting device 12. For example, if the alarm is employed, the anomaly is reported by warning sound. If the LED lamp is employed, the anomaly is reported by turning on and/or blinking the lamp in a warning color. If the display is employed, the anomaly is reported by displaying a warning message on the display.

With the wireless power transmission apparatus 1 (the power-supplying module 2 and the power-receiving module 3), a magnetic field resonant state (resonance phenomenon) is created between the power-supplying resonator 22 and the power-receiving resonator 32. The magnetic field resonant state created by having the power-supplying resonator 22 and the power-receiving resonator 32 resonate with each other enables power to be transmitted from the power-supplying resonator 22 to the power-receiving resonator 32 as magnetic field energy. Thus, the power is transmitted wirelessly from the charger 101 having the power-supplying module 2 to the wireless headset 102 having the power-receiving module 3, and the secondary battery 9 provided in the wireless headset 102 is charged.

(Formation of Magnetic Field Space)

In the present embodiment, the magnetic field space G1 with weakened magnetic field strength is formed to decrease the strength of the magnetic field generated inside and around the power-supplying module 2 and the power-receiving module 3. Specifically as shown in FIG. 2, when the power is supplied from the power-supplying resonator 22 of the power-supplying module 2 to the power-receiving resonator 32 of the power-receiving module 3 by utilizing the resonance phenomenon, the magnetic field space G1 having a lower magnetic field strength than that of nearby portions is formed in the vicinity of the power-supplying resonator 22 and the power-receiving resonator 32. The reason why the magnetic field space G1 is formed is to arrange the stabilizer circuit 7, the charging circuit 8, the secondary battery 9, and the like, which are desired to have less influence of the magnetic field, in this magnetic field space G1 having a lower magnetic field strength than that in nearby portions. Thereby, occurrence of eddy current attributed to the magnetic field is restrained or prevented. This restrains negative effects due to generation of heat, to the stabilizer circuit 7, the charging circuit 8, the secondary battery 9, and the like.

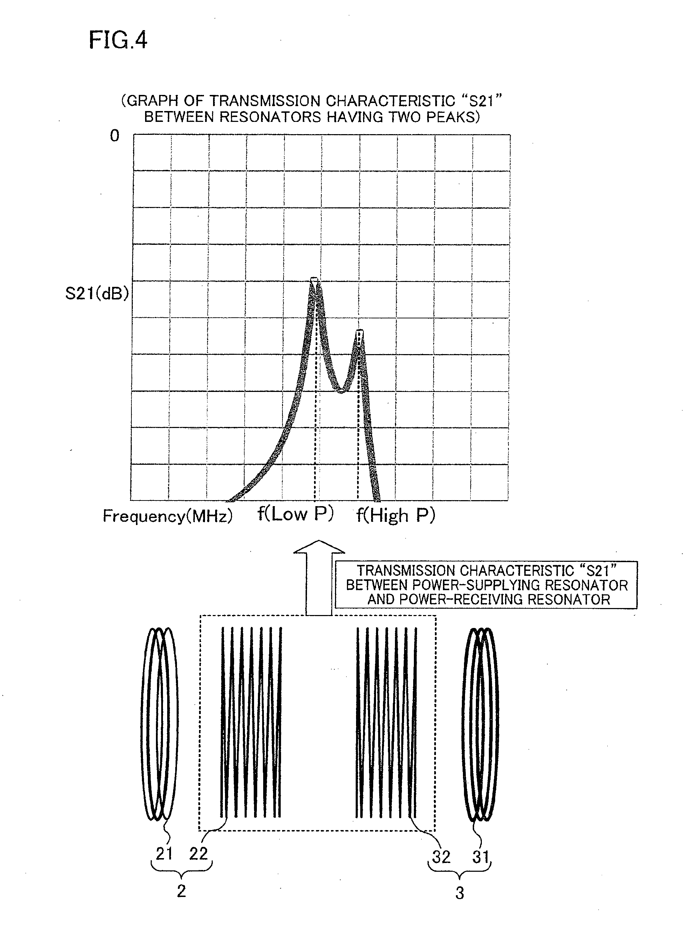

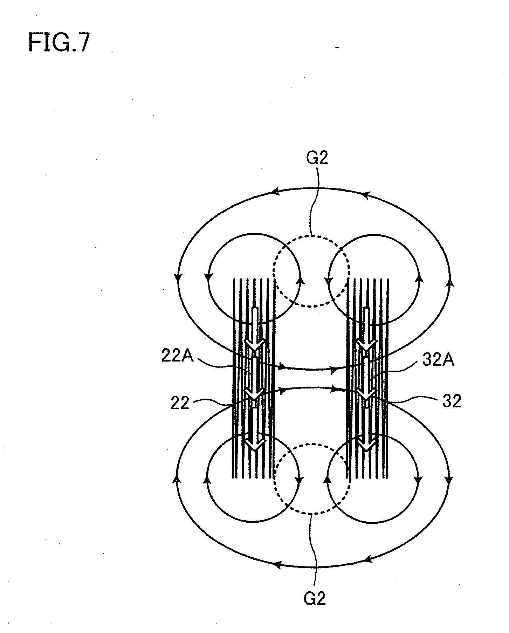

To form the magnetic field space G1, G2, setting is made so that: a graphical representation showing a transmission characteristic "S21" between the power-supplying resonator 22 and the power-receiving resonator 32 relative to the power-source frequency has two peak portions, as shown in FIG. 4; and the power-source frequency of the power supplied to the power-supplying module corresponds to either one of the two peak portions. In the present embodiment, as shown in FIG. 2, to form the magnetic field space G1 between the power-supplying resonator 22 and the power-receiving resonator 32, the power-source frequency is set so as to correspond to the higher peak portion (f (High P) ) which is on the higher frequency side between the two peak portions. If, it is desired to form the magnetic field space G2 outside the power-supplying resonator 22 and the power-receiving resonator 32 (see FIG. 7), the power-source frequency is set to correspond to the lower peak portion (f (Low P) ) which is on the lower frequency side between the two peak portions.

The transmission characteristic "S21" is formed of signals measured by a network analyzer 110 (e.g., E5061B produced by Agilent Technologies, Inc., see FIG. 5) connected to the wireless power transmission apparatus 1 (the power-supplying module 2 and the power-receiving module 3), and is indicated in decibel. The greater the value is, the higher the power transmission efficiency is. Further, the power transmission efficiency means a ratio of the power output to an input terminal 112 to the power supplied from an output terminal 111 to the power-supplying module 2, while the wireless power transmission apparatus 1 is connected to the network analyzer 110.

Specifically, as shown in FIG. 5, using the network analyzer 110, the transmission characteristic "S21" between the power-supplying resonator 22 and the power-receiving resonator 32 relative to the power-source frequency is analyzed for various power-source frequencies of the AC power supplied to the power-supplying resonator 22. In this regard, as shown in the graphical representation of FIG. 4, the horizontal axis indicates the power-source frequency of the AC power output from the output terminal 111, and the vertical axis indicates the transmission characteristic "S21". Now, in measurement for the transmission characteristic "S21" between the power-supplying resonator 22 and the power-receiving resonator 32, if coupling between the power-supplying coil 21 and the power-supplying resonator 22 is strong, it influences the coupling state between the power-supplying resonator 22 and the power-receiving resonator 32, which makes it impossible to accurately perform measurement for the transmission characteristic "S21" between the power-supplying resonator 22 and the power-receiving resonator 32. Therefore, the distance d12 between the power-supplying coil 21 and the power-supplying resonator 22 has to be kept so that: the power-supplying resonator 22 is fully excited; a magnetic field is generated by the power-supplying resonator 22; and the coupling between the power-supplying coil 21 and the power-supplying resonator 22 is as weak as possible. For the same reason, the distance d34 between the power-receiving resonator 32 and the power-receiving coil 31 has to be kept so that: the power-receiving resonator 32 is fully excited; a magnetic field is generated by the power-receiving resonator 32; and the coupling between the power-receiving resonator 32 and the power-receiving coil 31 is as weak as possible. Further, setting is made so that the analyzed waveform obtained by analyzing the transmission characteristic "S21" between the power-supplying resonator 22 and the power-receiving resonator 32 has the two peak portions as shown in FIG. 4: the lower peak portion (f (Low P)) formed on the lower frequency side; and the higher peak portion (f (High P)) formed on the higher frequency side.

The above-described analyzed waveform of the transmission characteristic "S21" between the power-supplying resonator 22 and the power-receiving resonator 32 having the two separate peak portions respectively on the lower frequency side and the higher frequency side is realized by: adjusting the distance d23 between the power-supplying resonator 22 and the power-receiving resonator 32; and/or adjusting variable parameters constituting the power-supplying resonator 22 and the power-receiving resonator 32. Such variable parameters include: the resistance value, inductance, capacity of capacitor, and coupling coefficients $K_{23}$ in the $R_2$, $L_2$, and $C_2$ of the RLC circuit of the power-supplying resonator 22, and the $R_3$, $L_3$, and $C_3$ of the RLC circuit of the power-receiving resonator 32.

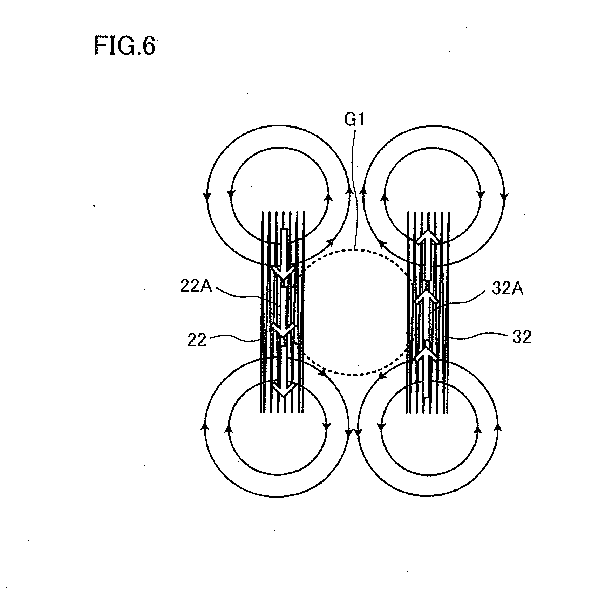

When, on an assumption that the analyzed waveform of the transmission characteristic "S21" between the power-supplying resonator 22 and the power-receiving resonator 32 has the two peak portions, the power-source frequency of the AC power supplied is set to the higher peak portion (f (High P) ) formed on the higher frequency side, the power-supplying resonator 22 and the power-receiving resonator 32 are resonant with each other in antiphase, and the current (22A) in the power-supplying resonator 22 and the current (32A) in the power-receiving resonator 32 flow in directions opposite to each other, as shown in FIG. 6. As a result, as the magnetic field vector diagram in FIG. 6 shows, because the magnetic field generated on the inner circumference side of the power-supplying resonator 22 and the magnetic field generated on the inner circumference side of the power-receiving resonator 32 cancel each other out, the magnetic field space G1 having a lower magnetic field strength than that in positions not on the inner circumference side of the power-supplying resonator 22 and the power-receiving resonator 32 (e.g., the magnetic field strength on the outer circumference side of the power-supplying resonator 22 and the power-receiving resonator 32) is formed on the inner circumference side of the power-supplying resonator 22 and the power-receiving resonator 32, as the influence of the magnetic fields is reduced. Note that the resonance state in which the current in the power-supplying resonator 22 and the current in the power-receiving resonator 32 flow in directions opposite to each other is referred to as an antiphase resonance mode.

Meanwhile, when, on the assumption that the analyzed waveform of the transmission characteristic "S21" between the power-supplying resonator 22 and the power-receiving resonator 32 has the two peak portions, the power-source frequency of the AC power supplied is set to the lower peak portion (f (Low P)) formed on the lower frequency side, the power-supplying resonator 22 and the power-receiving resonator 32 are resonant with each other in inphase, and the current (22A) in the power-supplying resonator 22 and the current (32A) in the power-receiving resonator 32 flow in the same direction, as shown in FIG. 7. As a result, as shown in the magnetic field vector diagram in FIG. 7, because the magnetic field generated on the outer circumference side of the power-supplying resonator 22 and the magnetic field generated on the outer circumference side of the power-receiving resonator 32 cancel each other out, the magnetic field space G2 having a lower magnetic field strength than that in positions not on the outer circumference side of the power-supplying resonator 22 and the power-receiving resonator 32 (e.g., the magnetic field strength on the inner circumference side of the power-supplying resonator 22 and the power-receiving resonator 32) is formed on the outer circumference side of the power-supplying resonator 22 and the power-receiving resonator 32, as the influence of the magnetic fields is reduced. Note that the resonance state in which the current in the power-supplying resonator 22 and the current in the power-receiving resonator 32 both flow in the same direction is referred to as an inphase resonance mode.

(Detection of Magnetic Field Strength Utilizing Formation of Magnetic Field Space)

As described above, in the wireless power transmission apparatus 1 having the above structure, the power-supplying resonator 22 and the power-receiving resonator 32 create the magnetic field resonant state, and thereby the magnetic field space G1, G2 is formed when wireless power transmission is performed. That is to say, the magnetic field space G1, G2 is formed in the situation where charging is possible from the charger 101 to the secondary battery 9 included in the wireless headset 102.

Thus, in the present application, the magnetic field detector 11 is disposed at the position where the magnetic field space G1, G2 is formed, to detect the magnetic field strength at this position, and based on this, determined is which of the following states occurs: the state where normal charging is performed from the charger 101 to the secondary battery 9 included in the wireless headset 102 (normal charging state) ; the state where the charger 101 is in the standby state (standby state) ; and the state where an anomaly occurs in the charging from the charger 101 to the secondary battery 9 included in the wireless headset 102 (abnormal state).

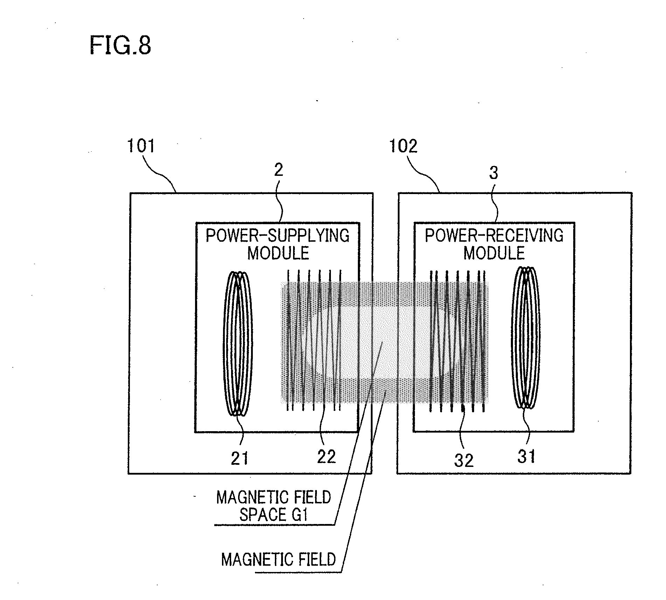

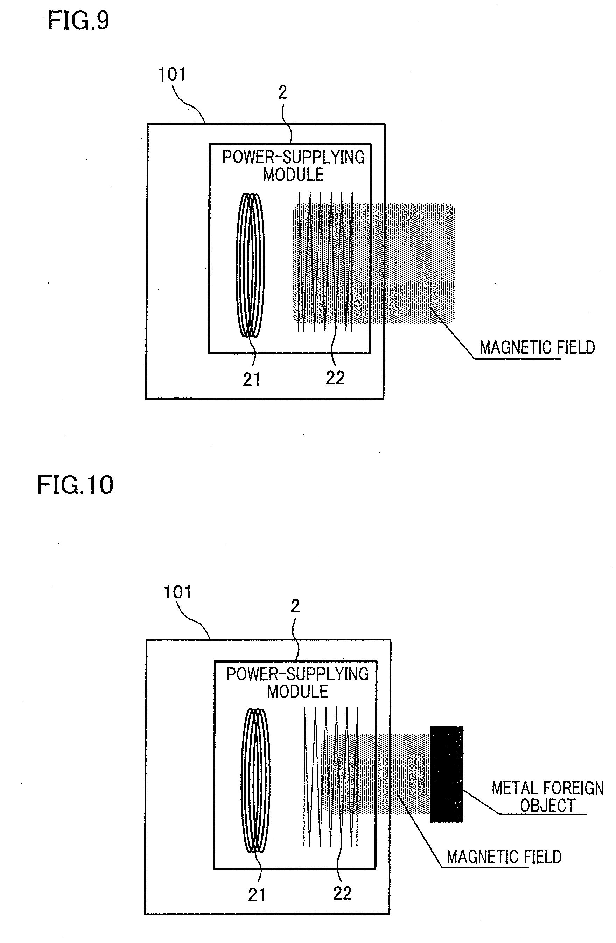

Specifically, as shown in FIG. 8, a magnetic field strength range for the normal charging from the charger 101 to the secondary battery 9 included in the wireless headset 102 is predetermined by preliminarily measuring the magnetic field strength in this state at the position where the magnetic field space G1 is formed (where the magnetic field detector 11 is disposed). When the magnetic field strength detected by the magnetic field detector 11 falls within the above range, it is determined that the normal charging is performed. Further, as shown in FIG. 9, a magnetic field strength range for the standby state where charging from the charger 101 to the secondary battery 9 included in the wireless headset 102 is not performed is predetermined by preliminarily measuring the magnetic field strength in this state at the position where the magnetic field space G1 is formed (where the magnetic field detector 11 is disposed). When the magnetic field strength detected by the magnetic field detector 11 falls within the above range, it is determined that the apparatus is in the standby state for charging.

When the magnetic field strength detected by the magnetic field detector 11 falls within neither the range for the normal charging nor the range for the standby state, it is determined that the abnormal state occurs regarding the charging from the charger 101 to the secondary battery 9 included in the wireless headset 102. If, for example, as shown in FIG. 10, a metal foreign object (such as a coin, nail, paper clip, and key) is placed in the vicinity of the power-supplying module 2, the metal foreign object is influenced by the magnetic field, to induce an eddy current. If such an eddy current occurs, excessive heat may occur in the metal foreign object and/or the power-supplying module 2. Thus, it should be determined that an anomaly occurs regarding charging from the charger 101 to the secondary battery 9 included in the wireless headset 102. Thus, by using the characteristic that if a metal foreign object is placed in the vicinity of the power-supplying module 2 the magnetic field strength is weakened compared with that in the standby state due to the influence to the magnetic field around the power-supplying module 2 by the metal foreign object, it is determined that a metal foreign object is placed in the vicinity of the power-supplying module 2 and that the abnormal state occurs regarding the charging when the magnetic field strength detected by the magnetic field detector 11 falls within neither the range for the normal charging nor the range for the standby state.

(Measurement Experiment)

Referring to Measurement Experiments 1 and 2, the following describes the magnetic field strengths in the normal charging state, the standby state, and the abnormal state.

In the wireless power transmission apparatus 1 used in Measurement Experiments 1 and 2, the power-supplying coil 21 is constituted by an RLC circuit whose elements include a resistor $R_1$, a coil $L_1$, and a capacitor $C_1$. For the coil $L_1$, copper wire material having a wire diameter of 0.2 mm is used, and the coil diameter is set to 9 mm$\phi$. Further, the power-supplying resonator 22 is constituted by an RLC circuit whose elements include a resistor $R_2$, a coil $L_2$, and a capacitor $C_2$. For the coil $L_2$, copper wire material having a wire diameter of 0.2 mm is used, and adopted is a solenoid coil with its coil diameter of 9 mm$\phi$. Further, the power-receiving resonator 32 is constituted by an RLC circuit whose elements include a resistor $R_3$, a coil $L_3$, and a capacitor $C_3$. For the coil $L_3$, copper wire material having a wire diameter of 0.1 mm is used, and adopted is a solenoid coil with its coil diameter of 8 mm$\phi$. Further, the power-receiving coil 31 is constituted by an RLC circuit whose elements include a resistor $R_4$, a coil $L_4$, and a capacitor $C_4$. For the coil $L_4$, copper wire material having a wire diameter of 0.1 mm is used, and the coil diameter is set to 8 mm$\phi$. Furthermore, on the inner circumference side of the power-supplying coil 21 and the power-supplying resonator 22, a cylindrical magnetic member having a thickness of 450 $\mu$m was disposed to further weaken the magnetic field strength of the to-be-formed magnetic field space G1 (to make the change in the measured magnetic field strength more prominent). In the same way, on the inner circumference side of power-receiving resonator 32 and the power-receiving coil 31, a cylindrical magnetic member having a thickness of 450 $\mu$m was disposed. The values of $R_1$, $R_2$, $R_3$, and $R_4$ in the wireless power transmission apparatus 1 used in Measurement Experiments 1 and 2 were set to 2 $\Omega$, 2.3 $\Omega$, 1.8 $\Omega$, and 1.2 $\Omega$, respectively. Further, the values of $L_1$, $L_2$, $L_3$, and $L_4$ were set to 11 $\mu$H, 15 $\mu$H, 7.7 $\mu$H, and 4.1 $\mu$H. Further, the values of $C_1$, $C_2$, $C_3$, and $C_4$ were set to 2.3 nF, 1.68 nF, 3.3 nF, and 6.2 nF, respectively. The resonance frequency of the power-supplying resonator 22 and that of the power-receiving resonator 32 was 1 MHz.

(Measurement Experiment 1)

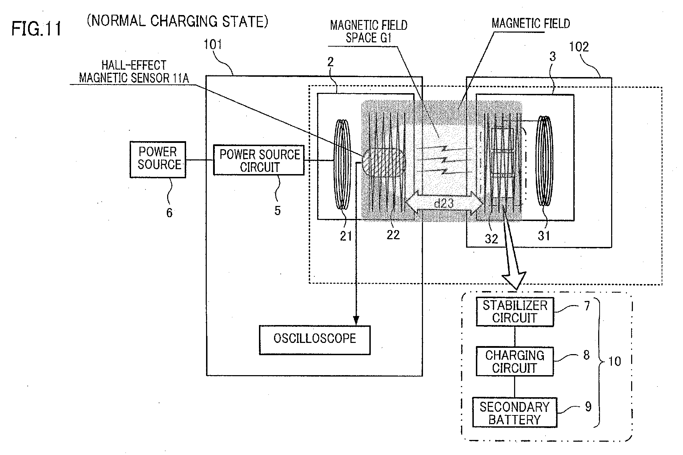

In Measurement Experiment 1, as shown in FIG. 11 to FIG. 13, a Hall-effect magnetic sensor 11A (made by Allegro Microsystems, LLC, A1324LUA, linear sensor) was disposed on the inner circumference side of the power-supplying resonator 22, and output voltages of the Hall-effect magnetic sensor 11A in the normal charging state, the standby state, and the abnormal state are measured using an oscilloscope (made by Agilent Technology, MSO-X3054A) connected to the Hall-effect magnetic sensor 11A. A change in the measured output voltage can be regarded as a change in the magnetic field strength because the output voltage of the Hall-effect magnetic sensor 11A is proportional to the magnetic field strength.

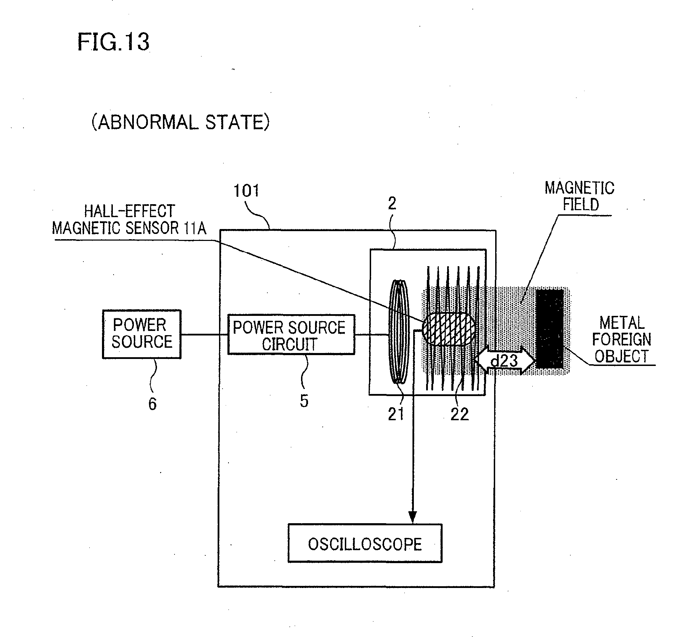

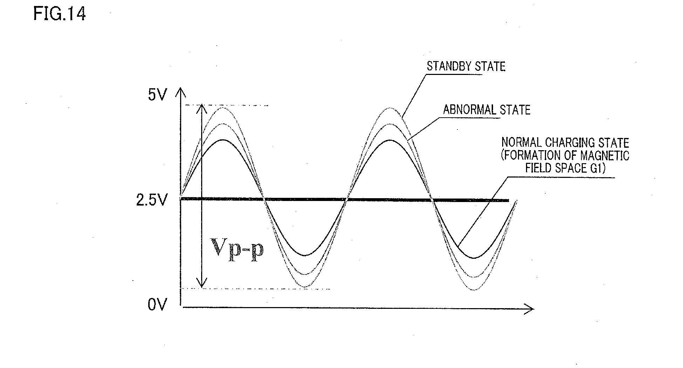

In Measurement Experiment 1, as shown in FIG. 14, the output voltage of the Hall-effect magnetic sensor 11A was measured under a voltage of DC 5V. When power supply is not performed from the power source 6 to the power-supplying module 2 under this condition, the output voltage measured by the magnetic field detector 11 was 2.5 V (see FIG. 14) because no magnetic field is generated. As for the value of the output voltage to be measured, an amplitude Vp-p was regarded as a detection voltage p-p, as shown in FIG. 14. The input power supplied to the power-supplying module 2 was set with a power-source frequency of 1080 kHz, a voltage of 5 V, and a current of 0.25 A. For measurement in the abnormal state, a copper piece of 5 mm x 5 mm x 0.5 mm, an aluminum piece of 5 mm x 5 mm x 0.5 mm, a copper piece of 10 mm x 10 mm x 0.5 mm, and an aluminum piece of 10 mm x 10 mm x 0.5 mm were used as metal foreign objects. As shown in FIG. 13, for each of the metal foreign objects, the output voltage was measured for each of the cases where: the object is placed at a distance of 3 mm from the power-supplying resonator 22 (d23 = 3 mm) ; and the object is placed at a distance of 2 mm from the power-supplying resonator 22 (d23 = 2 mm). For measurement in the normal charging state, the output voltage was measured for each of the cases where: the distance d23 between the power-supplying resonator 22 and the power-receiving resonator 32 is 3 mm; and the distance d23 is 2 mm.

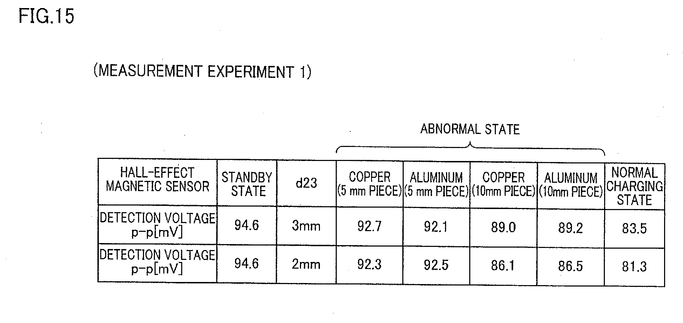

The measurement results are shown in FIG. 15. According to the measurement results, the detection voltage p-p in the standby state is 94.6 mV, which is the highest (the magnetic field strength is the highest.) The detection voltage p-p in the normal charging state under the condition of d23 = 3 mm (in the state where the magnetic field space G1 is formed) is 83.5 mV, which is the lowest (the magnetic field strength is the lowest.) The detection voltage p-p in each case of the abnormal state (the copper piece of 5 mm x 5 mm x 0.5 mm, the aluminum piece of 5 mm x 5 mm x 0.5 mm, the copper piece of 10 mm x 10 mm x 0.5 mm, and the aluminum piece of 10 mm x 10 mm x 0.5 mm are placed) under the condition of the distance of 3 mm from the power-supplying resonator 22 (d23 = 3 mm) is lower than that in the standby state and higher than that in the normal charging state. The same is applied to each of the cases under the condition of the distance d23 = 2 mm. The results show that, in the normal charging state, because the magnetic field space G1 having a lower magnetic field strength than that of nearby portions is formed in the wireless power transmission apparatus 1 as shown in FIG. 11, the detection voltage p-p measured by the Hall-effect magnetic sensor 11A in the magnetic field space G1 is the lowest. The results show that, if a metal foreign object is placed in the vicinity of the power-supplying module 2 to create the abnormal state, the magnetic field around the power-supplying module 2 is influenced by the metal foreign object, and thereby the magnetic field strength is lowered than that in the standby state.


(Measurement Experiment 2)

In Measurement Experiment 2, a magnetism detecting coil 11B is disposed on the inner circumference side of the power-supplying resonator 22, and output voltages of the magnetism detecting coil 11B in the normal charging state, the standby state, and the abnormal state were measured using the oscilloscope (made by Agilent Technology, MSO-X3054A) connected to the magnetism detecting coil 11B. The change in the measured output voltage can be regarded as the change in the magnetic field strength because the output voltage of the magnetism detecting coil 11B is proportional to the magnetic field strength. The magnetism detecting coil 11B is an RL circuit (R = 1.22 $\Omega$, L = 5 $\mu$H). For a coil portion thereof, copper wire material having a wire diameter of 0.12 mm is used, and its coil diameter is set to 5 mm$\phi$.

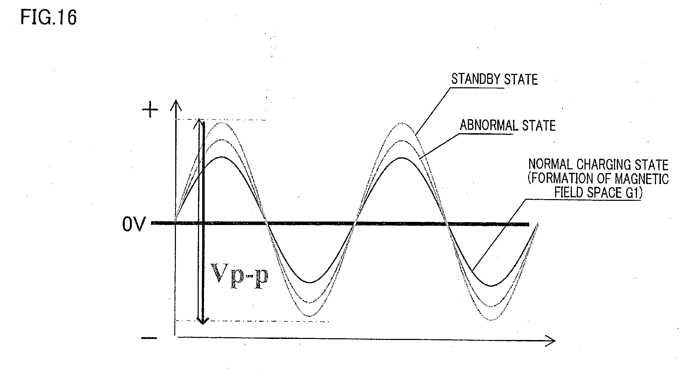

In Measurement Experiment 2, as for the value of the measured output voltage, an amplitude Vp-p is regarded as a detection voltage p-p, as shown in FIG. 16. The input power supplied to the power-supplying module 2 was set with a power-source frequency of 1080 kHz, a voltage of 5 V, and a current of 0.25 A. For measurement in the abnormal state, in the same manner as in Measurement Experiment 1, a copper piece of 5 mm x 5 mm x 0.5 mm, an aluminum piece of 5 mm x 5 mm x 0.5 mm, a copper piece of 10 mm x 10 mm x 0.5 mm, and an aluminum piece of 10 mm x 10 mm x 0.5 mm were used as metal foreign objects. For each of the metal foreign objects, the output voltage was measured for each of the cases where: the object is placed at a distance of 3 mm from the power-supplying resonator 22 (d23 = 3 mm); and the object is placed at a distance of 2 mm from the power-supplying resonator 22 (d23 = 2 mm) . For measurement in the normal charging state, the output voltage was measured for each of the cases where: the distance d23 between the power-supplying resonator 22 and the power-receiving resonator 32 is 3 mm; and the distance d23 is 2 mm.

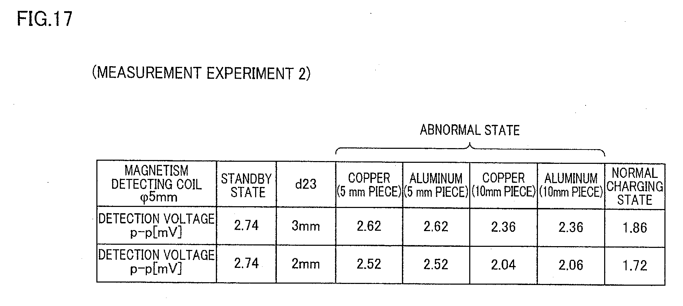

The measurement results are shown in FIG. 17. According to the measurement results, the detection voltage p-p in the standby state is 2.74 V, which is the highest (the magnetic field strength is the highest.) The detection voltage p-p in the normal charging state under the condition of d23 = 3 mm (in the state where the magnetic field space G1 is formed) is 1.86 V, which is the lowest (the magnetic field strength is the lowest) . The detection voltage p-p in each case of the abnormal state (the copper piece of 5 mm x 5 mm x 0.5 mm, the aluminum piece of 5 mm x 5 mm x 0.5 mm, the copper piece of 10 mm x 10 mm x 0.5 mm, and the aluminum piece of 10 mm x 10 mm x 0.5 mm are placed) under the condition of the distance of 3 mm from the power-supplying resonator 22 (d23 = 3 mm) is lower than that in the standby state and higher than that in the normal charging state. The same is applied to each of the cases under the condition of the distance d23 = 2 mm. The above shows that in the normal charging state, because the magnetic field space G1 having a lower magnetic field strength than that of nearby portions is formed in the wireless power transmission apparatus 1, the detection voltage p-p measured by the magnetism detecting coil 11B in the magnetic field space G1 is the lowest. The above also shows that, if a metal foreign object is placed in the vicinity of the power-supplying module 2 to create the abnormal state, the magnetic field around the power-supplying module 2 is influenced by the metal foreign object, and thereby the magnetic field strength is lowered than that in the standby state.

(Power-Supply Operation Flow of Wireless Power Transmission Apparatus 1)

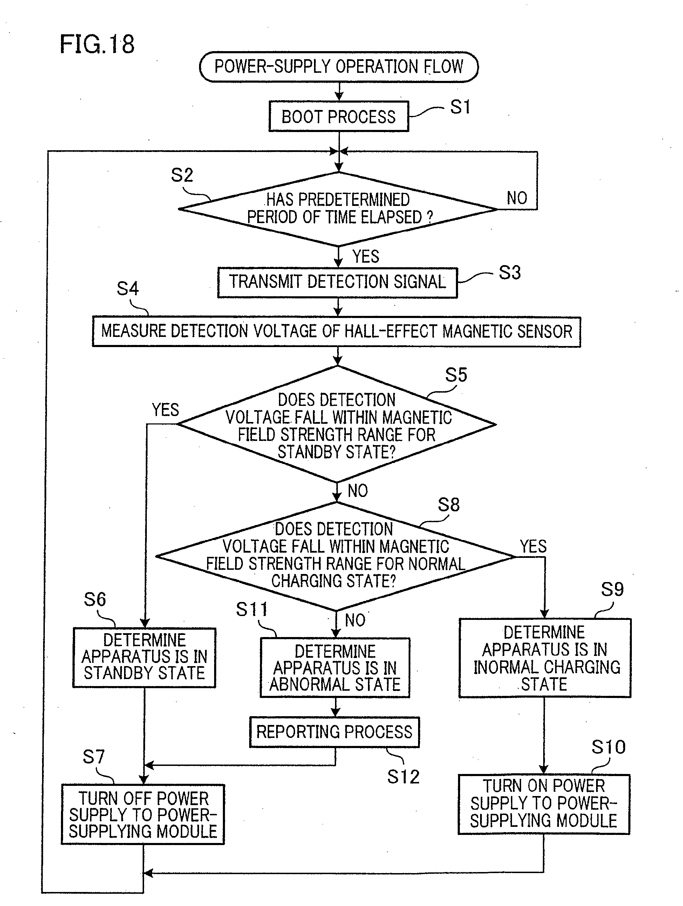

The following describes a power-supply operation in the wireless power transmission apparatus 1, in consideration of the above-described structure of the wireless power transmission apparatus 1 and the like. Specifically, the following describes the power-supply operation flow (processing) mainly executed by the determination control device 4 in the wireless power transmission apparatus 1, with reference to FIG. 18.

First, the determination control device 4 executes a predetermined boot process such as initialization (S1).

Then, the determination control device 4 determines whether a predetermined period of time has elapsed (S2). When the predetermined period of time has not elapsed (S2: NO), the determination control device 4 waits until the predetermined period of time has elapsed.

When the predetermined period of time has elapsed (S2: YES), the determination control device 4 transmits a detection signal to the power source circuit 5 (S3).

In the processes S2 and S3, the determination control device 4 transmits the detection signal to the power source circuit 5 with an interval of the predetermined period of time (the length of the predetermined period of time is freely settable) . Upon reception of the detection signal, the power source circuit 5 temporarily performs power supply to the power-supplying module 2, for a short time. With this, power is temporarily supplied to the power-supplying module 2, to create a magnetic field in the vicinity of the power-supplying resonator 22, which enables the detection of the output voltage (detection voltage) of the Hall-effect magnetic sensor 11A (detection of the magnetic field strength). Regarding the predetermined period of time set in S2, if the period is too short, power consumption required for the detecting operation is increased, while if the period is too long, accuracy in terms of time in detection is lowered. Thus, the period of time has to be determined in view of these regards.

Power is thus temporarily supplied to the power-supplying module 2, to create a magnetic field in the vicinity of the power-supplying resonator 22, and then, the detection voltage of the Hall-effect magnetic sensor 11A is measured (S4).

Then, the determination control device 4 determines whether the detection voltage measured in S4 falls within the magnetic field strength range for the standby state (S5). Referring to the measurement results of the Measurement Experiment 1 (see FIG. 15), for example, the detection voltage corresponding to the magnetic field strength in the standby state is 94.6 mV, and therefore "detection voltages not less than 94.6 mV" is stored in a storage device or the like in advance as the magnetic field strengths in the range for the standby state. Then, when the process of S5 is executed, the data indicating that the magnetic field strengths in the range for the standby state are not less than 94.6 mV is referred to.

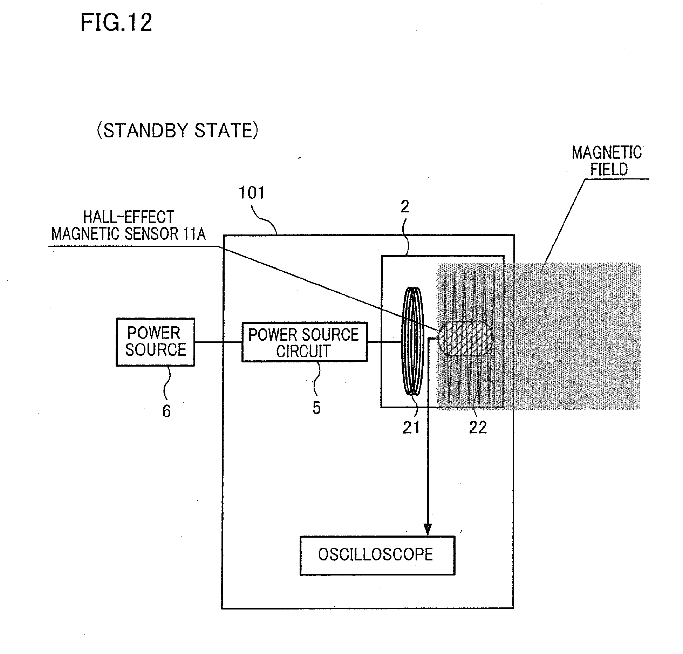

Then, when the detection voltage measured in S4 falls within the magnetic field strength range for the standby state (magnetic field strengths not less than 94.6 mV in the example of Measurement Experiment 1) (S5: YES), it is determined that the wireless power transmission apparatus 1 is in the standby state (S6). This is the state where the wireless headset 102 is not in the vicinity of the charger 101 (not within the rechargeable range), as shown in FIG. 12.

Then, when it is determined that the apparatus is in the standby state (S6), the determination control device 4 turns off the power supply to the power-supplying module 2 (S7). To be more specific, the determination control device 4 transmits a control signal to the power source circuit 5 to control the power source circuit 5, thereby to stop the power supply to the power-supplying module 2. With this, power consumption in the standby state is reduced.

Meanwhile, when the detection voltage measured in S4 does not fall within the magnetic field strength range for the standby state (the range of the magnetic field strengths not less than 94.6 mV in the example of Measurement Experiment 1) (S5: NO), the determination control device 4 determines whether the detection voltage measured in S4 falls within the magnetic field strength range for the normal charging state (S8). Referring to the measurement results of Measurement Experiment 1 (see FIG. 15), for example, the detection voltage corresponding to the magnetic field strength in the normal charging state is 83.5 mV, and therefore "detection voltages not more than 83.5 mV" is stored in a storage device or the like in advance as the magnetic field strengths in the range for the normal charging state. Then, when the process of S8 is executed, the data indicating that the magnetic field strengths in the range for the normal charging state are not more than 83.5 mV is referred to.

Then, when the detection voltage measured in S4 falls within the magnetic field strength range for the normal charging state (magnetic field strengths not more than 83.5 mV in the example of Measurement Experiment 1) (S8: YES), it is determined that the wireless power transmission apparatus 1 is in the normal charging state (S9). This is the state where the wireless headset 102 is in the vicinity of the charger 101 (within the rechargeable range), as shown in FIG. 11.

Then, when it is determined that the apparatus is in the normal charging state (S9), the determination control device 4 turns on the power supply to the power-supplying module 2 (S10). To be more specific, the determination control device 4 transmits a control signal to the power source circuit 5 to control the power source circuit 5, thereby to start the power supply to the power-supplying module 2.

Meanwhile, when the detection voltage measured in S4 does not fall within the magnetic field strength range for the normal charging state (the range of the magnetic field strengths not more than 83.5 mV in the example of Measurement Experiment 1) (S8: NO), the determination control device 4 determines that the wireless power transmission apparatus 1 is in the abnormal state (S11). That is to say, it is estimated that a metal foreign object is placed in the vicinity of the charger 101, as shown in FIG. 13.

When it is determined that the apparatus is in the abnormal state (S11), the determination control device 4 executes a reporting process of reporting, to the outside, an anomaly in the power supply, using the reporting device 12 (S12). For example, if an alarm is employed as the reporting device 12, the anomaly is reported by warning sound. If an LED lamp is employed, the anomaly is reported by turning on and/or blinking the lamp in a warning color. If a display is employed, the anomaly is reported by displaying a warning message on the display. ,

Then, after the reporting process of S12, the determination control device 4 turns off the power supply to the power-supplying module 2 (S7).

After the completion of the process of S7 or S10, the routine returns back to the process of S2. Thus, at intervals of the predetermined time, the state of the wireless power transmission apparatus 1 is monitored: which state occurs among the standby state, the normal charging state, or the abnormal state.

(Advantageous Effects)

With the above structure, the magnetic field generated around the power-supplying module 2 and the magnetic field generated around the power-receiving module 3 cancel each other out when power is supplied from the power-supplying module 2 to the power-receiving module 3 utilizing resonance phenomenon, and thereby the magnetic field space G1, G2 having a lower magnetic field strength than that of nearby portions is formed in the vicinity of the power-supplying module 2 and the power-receiving module 3. The magnetic field strength is detected using the magnetic field detector 11 disposed in the magnetic field space G1, G2, and based on the value of the detected magnetic field strength, an anomaly in power supply (abnormal state) is detected. Thus, it is possible to achieve safe power supply while preventing an increase in size of the wireless power transmission apparatus 1.

In addition, when an anomaly in power supply (abnormal state) is detected, power supply to the power-supplying module 2 is stopped, and thereby occurrence of malfunction due to abnormal power supply is prevented.

Moreover, when an anomaly in power supply (abnormal state) is detected, the abnormal state is reported to the outside using the reporting device 12.

Further, in the above-described structure, the coupling coefficient indicating the strength of coupling between the power-supplying resonator 22 and the power-receiving resonator 32 is increased when the magnetic field space G1 having a lower magnetic field strength than that of nearby portions is formed. When the transmission characteristic "S21" (which is an index of the power transmission efficiency in the power transmission from the power-supplying module 2 to the power-receiving module 3) is analyzed while the coupling coefficient is high as above, the analyzed waveform of the transmission characteristic "S21" has separate peaks; one on the low frequency side and another on the high frequency side. By setting the power-source frequency to the frequency on the high frequency side, the current in the power-supplying resonator 22 and the current in the power-receiving resonator 32 flow in directions opposite to each other. With this, as the magnetic field generated on the inner circumference side of the power-supplying module 2 and the magnetic field generated on the inner circumference side of the power-receiving module 3 cancel each other out, the influence of the magnetic fields is reduced, and thereby the magnetic field space G1 having a lower magnetic field strength than that of nearby portions is formed on the inner circumference side of the power-supplying resonator 22. Further, the magnetic field detector 11 is disposed on the inner circumference side of the power-supplying resonator 22 where the magnetic field space G1 is formed, and thereby, the space on the inner circumference side of the power-supplying resonator 22 is effectively utilized, leading to downsizing of the wireless power transmission apparatus 1.

Furthermore, in the above structure, the Hall-effect magnetic sensor 11A is used as the magnetic field detector 11. This makes it possible to detect the magnetic field strength with high accuracy and to downsize the wireless power transmission apparatus 1 because the Hall-effect magnetic sensor 11A is small in size.

In the meantime, when the magnetism detecting coil 11B is used as the magnetic field detector 11, the production cost of the wireless power transmission apparatus 1 is reduced. As for the magnetism detecting coil 11B, it is possible to change its size (such as the diameter, thickness, number of turns, and wire diameter of the coil) to some extent. This enables the size of the coil to be adjusted depending on the size of and/or the space in the wireless power transmission apparatus 1.

(Arrangement to Enhance Sensitivity in Detection of Magnetic Field Strength)

The following describes an arrangement to enhance the sensitivity in the detection of the magnetic field strength. As described above, the change in the measured output voltage of the Hall-effect magnetic sensor 11A or the like can be regarded as the change in the magnetic field strength because the output voltage is proportional to the magnetic field strength. Concerning the magnetic field strength in each of the normal charging state, the standby state, and the abnormal state, i.e. , the output voltage of the magnetic field detector such as the Hall-effect magnetic sensor 11A, the higher the voltage is, the higher the detection accuracy is. Assuming that the output voltage of the magnetic field detector such as the Hall-effect magnetic sensor 11A varies depending on the location of the magnetic field detector, it is desired to dispose the magnetic field detector such as the Hall-effect magnetic sensor 11A at a location where the output voltage is high. In view of the above, the following describes where of the wireless power transmission apparatus 1 capable of forming the above magnetic field space is preferable to dispose the magnetic field detector such as the Hall-effect magnetic sensor 11A.

To be more specific, with reference to Measurement Experiment 3, described is where is preferable to dispose the Hall-effect magnetic sensor 11A inside the coils of the power-supplying coil 21 and the power-receiving resonator 32. Further, referring to Measurement Experiment 4, also described is in which orientation of the Hall-effect magnetic sensor 11A should be disposed.

(Measurement Experiment)

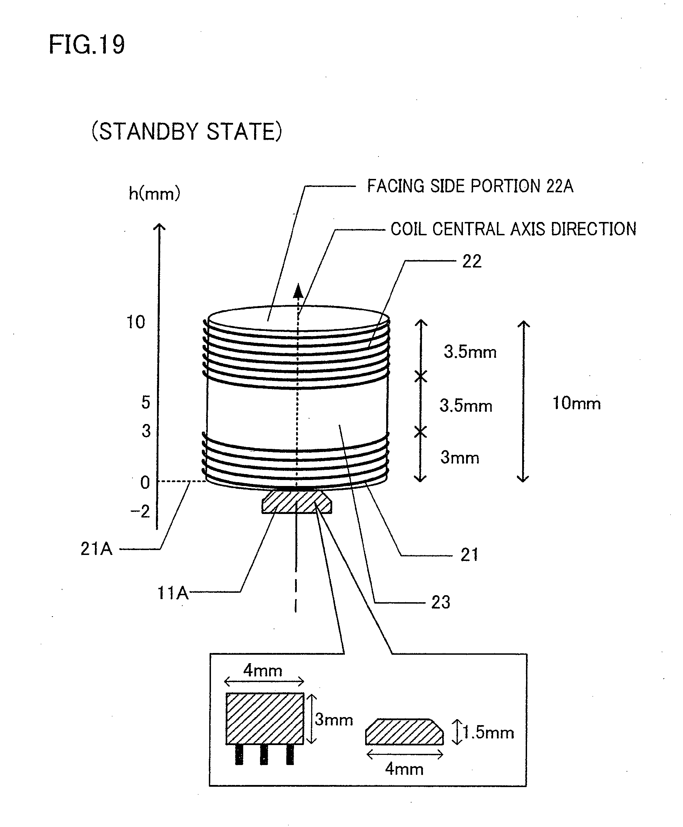

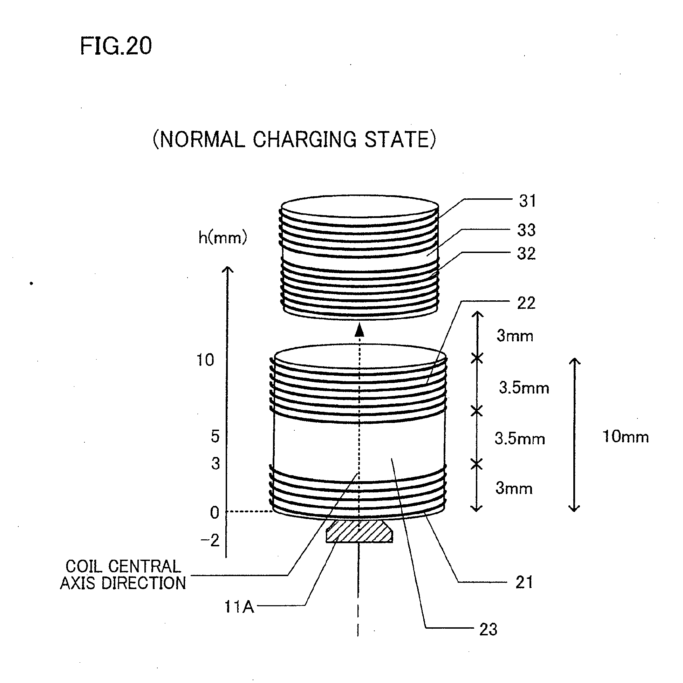

As shown in FIG. 19, in the wireless power transmission apparatus 1 used in Measurement Experiments 3 and 4, the power-supplying coil 21 is constituted by an RLC circuit whose elements include a resistor $R_1$, a coil $L_1$, and a capacitor $C_1$. For the coil $L_1$, copper wire material having a wire diameter of 0.12 mm is used, and the coil diameter is set to 11 mm$\phi$. The power-supplying resonator 22 is constituted by an RLC circuit whose elements include a resistor $R_2$, a coil $L_2$, and a capacitor $C_2$. For the coil $L_2$, copper wire material having a wire diameter of 0.12 mm is used, and adopted is a solenoid coil with its coil diameter of 11 mm$\phi$. Further, as shown in FIG. 20, the power-receiving resonator 32 is constituted by an RLC circuit whose elements include a resistor $R_3$, a coil $L_3$, and a capacitor $C_3$. For the coil $L_3$, copper wire material having a wire diameter of 0.1 mm is used, and adopted is a solenoid coil with its coil diameter of 9 mm$\phi$. The power-receiving coil 31 is constituted by an RLC circuit whose elements include a resistor $R_4$, a coil $L_4$, and a capacitor $C_4$. For the coil $L_4$, copper wire material having a wire diameter of 0.1 mm is used, and the coil diameter is set to 9 mm$\phi$. On the inner circumference side of the power-supplying coil 21 and the power-supplying resonator 22, a cylindrical magnetic member 23 having a thickness of 450 $\mu$m was disposed to further weaken the magnetic field strength of the to-be-formed magnetic field space G1 (to make the change in the measured magnetic field strength more prominent). In the same way, on the inner circumference side of the power-receiving resonator 32 and the power-receiving coil 31, a cylindrical magnetic member 33 having a thickness of 450$\mu$m was disposed. The values of $R_1$, $R_2$, $R_3$, and $R_4$ in the wireless power transmission apparatus 1 used in Measurement Experiments 3 and 4 were set to 1.9 $\Omega$, 2.5 $\Omega$, 1.7 $\Omega$, and 2 Q, respectively. Further, the values of $L_1$, $L_2$, $L_3$, and $L_4$ were set to 12.5 $\mu$H, 18.8 $\mu$H, 7 $\mu$H, and 5.5 $\mu$H. Further, the values of $C_1$, $C_2$, $C_3$, and $C_4$ were set to 2 nF, 1.33 nF, 3.6 nF, and 4.7 nF, respectively. The resonance frequency of the power-supplying resonator 22 and that of the power-receiving resonator 32 was 1 MHz.

Further, as shown in FIG. 19, in the power-supplying module 2, the power-supplying coil 21 is formed in a solenoid shape with a thickness of 3 mm in a direction of its coil central axis direction ("coil central axis direction"). Meanwhile, the power-supplying resonator 22 is formed in a solenoid shape with a thickness of 3.5 mm in the coil central axis direction. The distance between the power-supplying coil 21 and the power-supplying resonator 22 is set to 3.5 mm in the coil central axis direction, as shown in FIG. 19.

Further, as shown in FIG. 20, the distance d23 between the power-supplying resonator 22 and the power-receiving resonator 32 is set to 3 mm in the normal charging state.

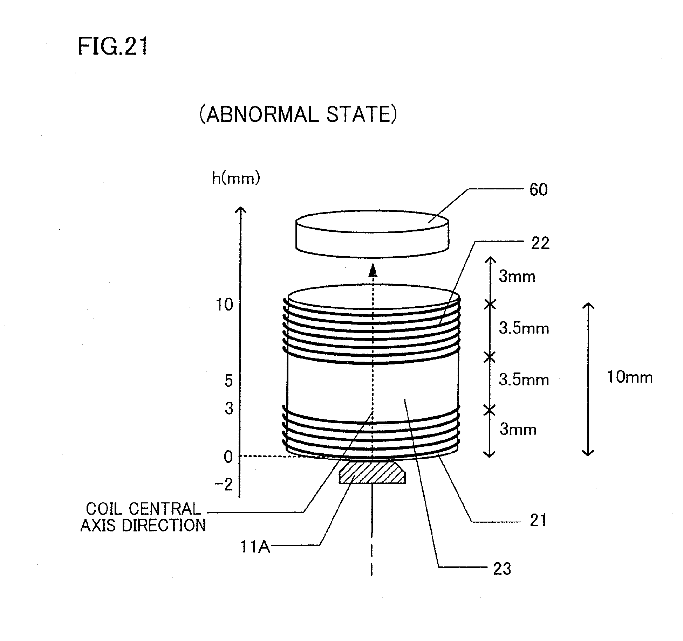

Furthermore, as shown in FIG. 21, as a metal foreign object 60 for creating the abnormal state, used are: a circular copper plate having diameter of 9 mm$\phi$ and a thickness of 0.5 mm; and a cylindrical zinc-air battery having a diameter of 11.6 mm$\phi$ and a thickness of 5.4 mm. The distance 23 between the power-supplying resonator 22 and the metal foreign object 60 is set to 3 mm.

(Measurement Experiment 3)

In Measurement Experiment 3, as shown in FIG. 19 to FIG. 21, in the wireless power transmission apparatus 1 where the standby state (FIG. 19), the normal charging state (FIG. 20), and the abnormal state (FIG. 21) are created, the Hall-effect magnetic sensor 11A (made by Allegro Microsystems, LLC, A1324LUA, linear sensor) was disposed at different positions on the inner circumference side of the power-supplying coil 21 and the power-supplying resonator 22, and the output voltage of the Hall-effect magnetic sensor 11A was measured using an oscilloscope (made by NF CORPORATION, GDS2064) connected to the Hall-effect magnetic sensor 11A.

As shown in FIG. 19, the Hall-effect magnetic sensor 11A is a magnetic field detector in the shape of a thin plate having a length of 3 mm, a width of 4 mm, and a thickness of 1.5 mm. The sensor 11A incorporates therein a thin plate-like semiconductor, and is configured to detect the magnetic field strength by means of Hall effect to the thin plate-like semiconductor.

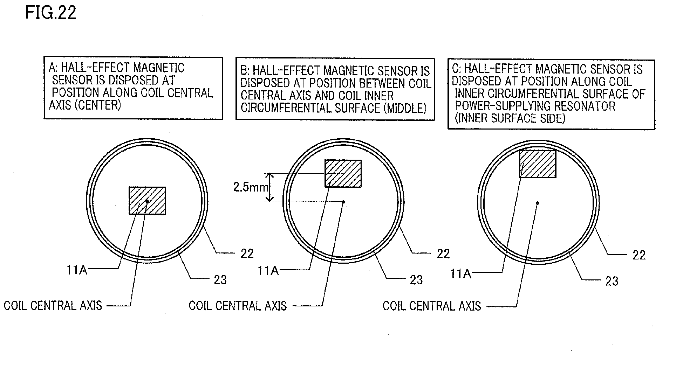

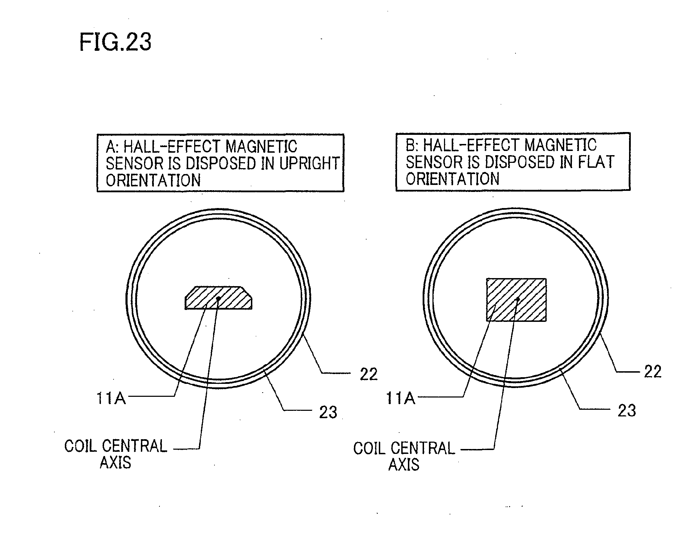

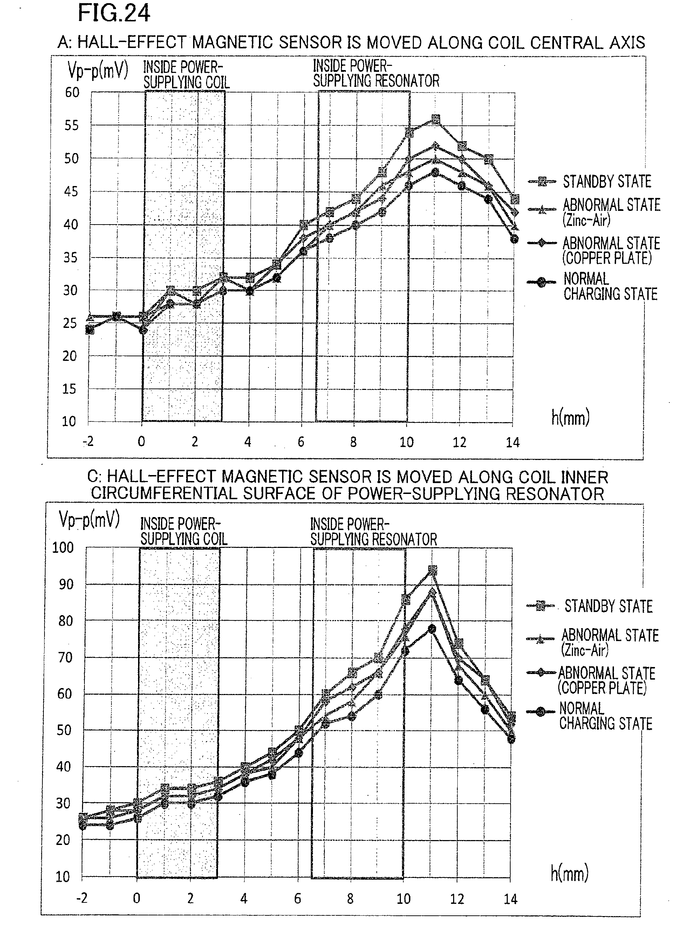

A first experiment of Measurement Experiment 3 will be specified. In the wireless power transmission apparatus 1 where the standby state (FIG. 19), the normal charging state (FIG. 20), and the abnormal state (FIG. 21) are created, the output voltage of the Hall-effect magnetic sensor 11 was measured while the Hall-effect magnetic sensor 11A in a flat orientation (see Section B of FIG. 23) was moved along the coil central axis (see Section A of FIG. 22) from a position of an outer side portion (21A) of the power-supplying coil 21 toward the power-receiving resonator 32. In other words, the output voltage of the Hall-effect magnetic sensor 11A was measured while the Hall-effect magnetic sensor 11A was moved along the coil central axis of the solenoid coil included in the power-supplying resonator 22 from the position (see 21A) where the power-supplying resonator 22 does not face the power-receiving resonator 32 during the power supply to another position (of facing side portion 22A: see FIG. 19) where the power-supplying resonator 22 faces the power-receiving resonator 32. The measurement results are shown in Section A of FIG. 24.

Note that, as shown in Section B of FIG. 23, the Hall-effect magnetic sensor 11A in the flat orientation means the Hall-effect magnetic sensor 11A oriented so that a plate surface of the thin plate-like semiconductor incorporated in the Hall-effect magnetic sensor 11A is orthogonal to the coil central axis direction. Meanwhile, as shown in Section A of FIG. 23, the Hall-effect magnetic sensor 11A in an upright orientation means the Hall-effect magnetic sensor 11A oriented so that the plate surface of the thin plate-like semiconductor incorporated in the Hall-effect magnetic sensor 11A is parallel to the coil central axis direction.

The horizontal axis h (mm) in each measurement result of FIG. 24 represents the distance in the coil central axis direction from the position of the outer side portion (21A) of the power-supplying coil 21 to the position of the facing side portion 22A. The position of the outer side portion is defined as a base point of "0 mm", as shown in FIG. 19 to FIG. 21. Meanwhile, the vertical axis represents the value of the output voltage Vp-p (mV) of the Hall-effect magnetic sensor 11A. A solid line connecting measured values indicated with squares represents the output voltage of the Hall-effect magnetic sensor 11A in the standby state. A solid line connecting measured values indicated with triangles represents the output voltage of the Hall-effect magnetic sensor 11A in the abnormal state where the zinc-air battery is used as the metal foreign object 60. A solid line connecting measured values indicated with rhombuses represents the output voltage of the Hall-effect magnetic sensor 11A in the abnormal state where the copper plate is used as the metal foreign object 60. A solid line connecting measured values indicated with circles represents the output voltage of the Hall-effect magnetic sensor 11A in the normal charging state.

Now, a second experiment of Measurement Experiment 3 will be described. In the wireless power transmission apparatus 1 where the standby state (FIG. 19), the normal charging state (FIG. 20), and the abnormal state (FIG. 21) are created, the output voltage of the Hall-effect magnetic sensor 11 was measured while the Hall-effect magnetic sensor 11A in the flat orientation (see Section B of FIG. 23) was moved along a coil inner circumferential surface of the power-supplying resonator 22 (see Section C of FIG. 22) from the position of the outer side portion (21A) of the power-supplying coil 21 toward the power-supplying resonator 22. In other words, the output voltage of the Hall-effect magnetic sensor 11A was measured while the Hall-effect magnetic sensor 11A was moved along the coil inner circumferential surface of the solenoid coil included in the power-supplying resonator 22, from the position (see 21A) where the power-supplying resonator 22 does not face the power-receiving resonator 32 during the power supply to the other position (the facing side portion 22A: see FIG. 19) where the power-supplying resonator 22 faces the power-receiving resonator 32. The measurement results are shown in Section C of FIG. 24.

The measurement results of Sections A and C of FIG. 24 show that the output voltages of the Hall-effect magnetic sensor 11A moved along the coil inner circumferential surface of the power-supplying resonator 22 (the case shown in Section C of FIG. 24) are higher than those of the Hall-effect magnetic sensor 11A moved along the coil central axis (the case shown in Section A of FIG. 24). That is, detection of the output voltage by the magnetic field detector such as the Hall-effect magnetic sensor 11A is easier and the detection accuracy is higher in the case where the Hall-effect magnetic sensor is disposed closer to the coil inner circumferential surface of the power-supplying resonator 22 than in the case where the Hall-effect magnetic sensor 11A is disposed at a position along the coil central axis.

The measurement results of Sections A and C of FIG. 24 also show that in both cases, the output voltage of the Hall-effect magnetic sensor 11A increases as the Hall-effect magnetic sensor 11A is moved from the position of the outer side portion 21A of the power-supplying coil 21 (h=0 mm) to the position of the facing side portion 22A of the power-supplying resonator 22 (h=10 mm). The above shows that detection of the output voltage by the magnetic field detector such as the Hall-effect magnetic sensor 11A is easier and the detection accuracy is higher in the case where the Hall-effect magnetic sensor is disposed at the position closer to the facing side portion 22A of the power-supplying resonator 22 than in the case where the sensor is disposed at the position closer to the outer side portion 21A of the power-supplying coil 21.

According to the measurement results of Sections A and C of FIG. 24, the output voltage measured by the Hall-effect magnetic sensor 11A reaches the highest value at the location of h=11 mm, that is the location where the Hall-effect magnetic sensor 11A is 1 mm closer to the power-receiving resonator 32 than the facing side portion 22A of the power-supplying resonator 22. Thus, if it is possible in terms of the structure of the power-supplying module 2, the Hall-effect magnetic sensor 11A may be disposed at the location which is a little closer to the power-receiving resonator 32 than the facing side portion 22A of the power-supplying resonator 22, to obtain the greatest detection accuracy of the output voltage. However, to achieve an intention of making the apparatus compact by disposing the Hall-effect magnetic sensor 11A inside the coil of the power-supplying resonator 22, the Hall-effect magnetic sensor 11A should be disposed closer to the coil inner circumferential surface of the power-supplying resonator 22 and on a plane defined by the facing side portion 22A of the power-supplying resonator 22 (h=10 mm).

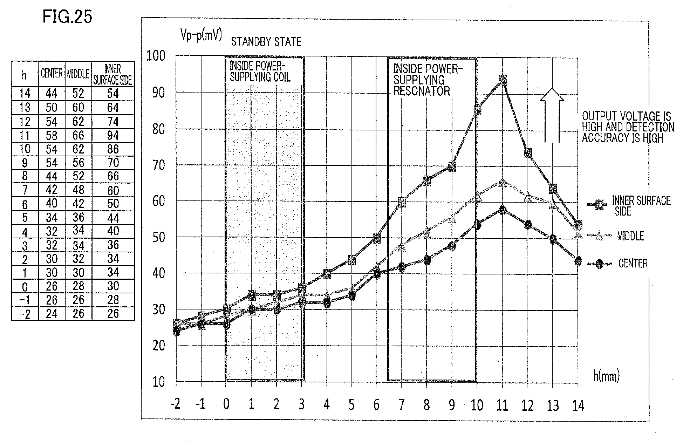

Now, a third experiment of Measurement Experiment 3 will be described. In the wireless power transmission apparatus 1 where the standby state (FIG. 19) is created, the output voltage of the Hall-effect magnetic sensor 11 was measured while the Hall-effect magnetic sensor 11A in the flat orientation (see Section B of FIG. 23) was moved in the coil central axis direction along an axis at a distance of 2.5 mm from the coil central axis to the coil inner circumferential surface (see Section B of FIG. 22), from the position of the outer side portion (21A) of the power-supplying coil 21 toward the power-supplying resonator 22. The measurement result is indicated by a solid line connecting measured values indicated with triangles ("middle") in FIG. 25. In FIG. 25, the measurement result in the standby state in Section A of FIG. 24 (where the Hall-effect magnetic sensor 11A is disposed along the coil central axis) is indicated by a solid line connecting measured values indicated with circles ("center"). Further, in FIG. 25, the measurement result in the standby state in Section C of FIG. 24 (where the Hall-effect magnetic sensor 11A is disposed along the coil inner circumferential surface) is indicated by a solid line connecting measured values indicated by squares ("center").

The measurement results of FIG. 25 show that the output voltage measured by the Hall-effect magnetic sensor 11A increases as the Hall-effect magnetic sensor 11A is moved from the position along the coil central axis (see Section A of FIG. 22) toward the coil inner circumferential surface of the power-supplying resonator 22 (see Section C in FIG. 22) via the position which is 2.5 mm distant from the coil central axis to the coil inner circumferential surface (see Section B in FIG. 22). That is, detection of the output voltage by the magnetic field detector such as the Hall-effect magnetic sensor 11A is easier and the detection accuracy is higher in the case where the Hall-effect magnetic sensor is disposed closer to the coil inner circumferential surface of the power-supplying resonator 22, rather than the coil central axis.

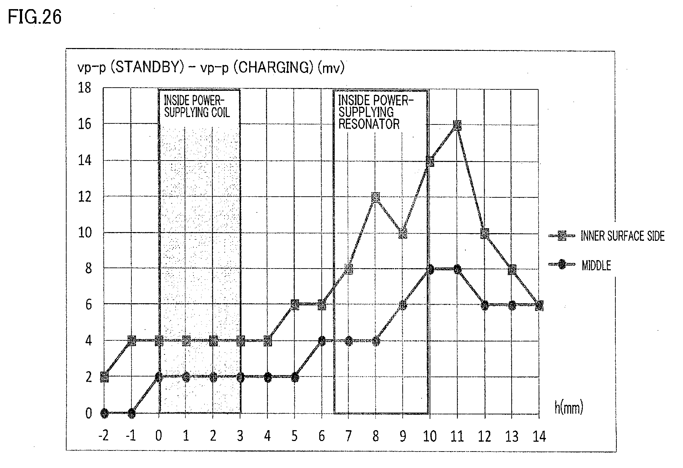

In FIG. 26, values each obtained by subtracting the output voltage in the normal charging state measured in the first experiment of Measurement Experiment 3 from the corresponding output voltage in the standby state are indicated by a solid line connecting values indicated with circles ("center"). Similarly, values each obtained by subtracting the output voltage in the normal charging state measured in the second experiment of Measurement Experiment 3 from the corresponding output voltage in the standby state are indicated by a solid line connecting values indicated with squares ("inner circumference side").

The results of FIG. 26 show that each difference between the output voltage in the standby state and that of the normal charging state is larger in the case where the Hall-effect magnetic sensor 11A is disposed at a position along the coil inner circumferential surface of the power-supplying resonator 22 than in the case where the Hall-effect magnetic sensor 11A is disposed at a position along the coil central axis. The larger the value obtained by subtracting the output voltage in the normal charging state from the output voltage in the standby state, the larger the difference between the output voltage in the normal charging state and the output voltage in the standby state is, and therefore, the possibility of erroneous detection is decreased as compared with the case where the difference between the output voltage in the normal charging state and the output voltage in the standby state is smaller. It can be said that, with this, detection of the output voltage by the magnetic field detector such as the Hall-effect magnetic sensor 11A is easier and the detection accuracy is higher.

(Measurement Experiment 4)

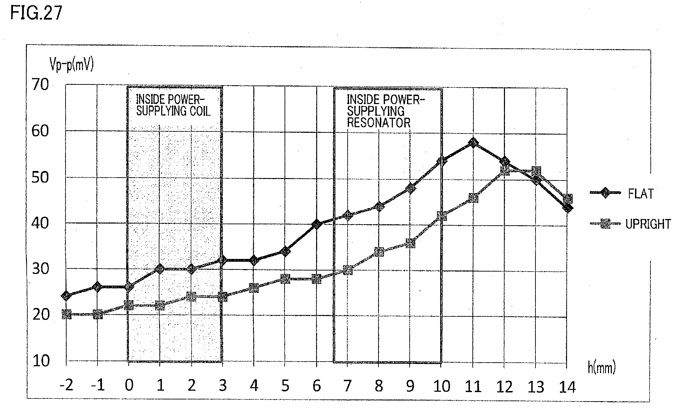

Measurement Experiment 4 will be described. In the wireless power transmission apparatus 1 where the standby state (see FIG. 19) is created, the output voltages of the Hall-effect magnetic sensor 11A (made by Allegro Microsystems, LLC, A1324LUA, linear sensor) in different orientations with respect to the coil central axis were measured using the oscilloscope (made by NF CORPORATION, GDS2064) connected to the Hall-effect magnetic sensor 11A. To be more specific, measured were: the output voltage of the Hall-effect magnetic sensor 11A in the upright orientation (Section A of FIG. 23) and that of the Hall-effect magnetic sensor 11A in the flat orientation (Section B of FIG. 23). The measurement results are shown in FIG. 27. In FIG. 27, the measurement result of the Hall-effect magnetic sensor 11A in the upright orientation (Section A of FIG. 23) is indicated by a solid line connecting measured values indicated with squares ("upright"). Meanwhile, the measurement result of the Hall-effect magnetic sensor 11A in the flat orientation (Section B of FIG. 23) is indicated by a solid line connecting measured values indicated with rhombuses ("flat").

The measurement results of FIG. 27 show that the output voltage of the Hall-effect magnetic sensor 11A is higher in the case where the Hall-effect magnetic sensor 11A is disposed in the flat orientation than in the case where the Hall-effect magnetic sensor 11A is disposed in the upright orientation. That is, detection of the output voltage by the magnetic field detector such as the Hall-effect magnetic sensor 11A is easier and the detection accuracy is higher in the case where the Hall-effect magnetic sensor 11A is disposed in the flat orientation than in the case where the Hall-effect magnetic sensor 11A is disposed in the upright orientation.

(Advantageous Effects)

According to the above, the sensitivity to detect the magnetic field strength is enhanced by disposing the Hall-effect magnetic sensor 11A closer to the inner circumferential surface of the coil of the power-supplying resonator 22 rather than the coil central axis of the power-supplying resonator 22, as compared with the case where the Hall-effect magnetic sensor 11A is disposed at a position along the coil central axis of the power-supplying resonator 22.

The sensitivity to detect the magnetic field strength is further enhanced by disposing the Hall-effect magnetic sensor 11A at a position along the inner circumferential surface of the coil of the power-supplying resonator 22.

The sensitivity to detect the magnetic field strength is further enhanced by disposing the case where the Hall-effect magnetic sensor 11A on the inner circumference side of the coil of the power-supplying resonator 22, and closer to the facing portion (facing side portion 22A) of the coil of the power-supplying resonator 22 which faces the coil of the power-receiving resonator 32 than the other portion (21A) thereof which does not face the coil of the power-receiving resonator 32, as compared with the case where the Hall-effect magnetic sensor 11A is disposed closer to the other portion which does not face the coil of the power-receiving resonator 32.

The sensitivity to detect the magnetic field strength is further enhanced by disposing the Hall-effect magnetic sensor 11A at a position on a plane defined by the facing portion (facing side portion 22A) of the coil of the power-supplying resonator 22 which faces the coil of the power-receiving resonator 32.

The sensitivity to detect the magnetic field strength is further enhanced by disposing the Hall-effect magnetic sensor 11A so that the plate surface of the thin plate-like semiconductor incorporated in the sensor 11A is orthogonal to the coil central axis direction (in the flat orientation), on the inner circumference side of the coil of the power-supplying resonator 22, as compared with the case where the sensor 11A is disposed in the upright orientation.

(Other Embodiments)

Although the above description deals with the charger 101 and the wireless headset 102 as an example, the disclosure is applicable to any devices having a rechargeable battery, such as tablet PCs, digital cameras, mobile phones, earphone-type music player, hearing aids, and sound collectors.

Further, the above description deals with a case where the power-supplied electronic device 10 includes the secondary battery 9; however, it is possible to adopt, as the power-supplied devices 10, a machine that directly consumes power for its operation.

Further, although the above description assumes the power-supplying module 2 and the power-receiving module 3 are mounted in a portable electronic device, the use of such an apparatus is not limited to such small devices. For example, with a modification to the specifications according to the required power amount, the power-supplying module 2 and the power-receiving module 3 are mountable to a relatively large device such as a wireless charging system in an electronic vehicle (EV), or to an even smaller device such as a wireless endoscope for medical use.

While the above description deals with a case where the magnetic field space G1 having a lower magnetic field strength than that of nearby portions is formed on the inner circumference side of the power-supplying resonator 22 as a result of reduction of the influence of the magnetic fields, the magnetic field space G2 may be formed as follows: when the analyzed waveform of the transmission characteristic "S21" between the power-supplying resonator 22 and the power-receiving resonator 32 has the two peak portions, the power-source frequency of the AC power supplied is set to the lower peak portion (f (Low P)) formed on the lower frequency side. Then the influence of the magnetic fields is reduced, and as shown in FIG. 5, the magnetic field space G2 having a lower magnetic field strength than that in a position other than on the outer circumference side of the power-supplying resonator 22 and the power-receiving resonator 32 (e.g., than that on the inner circumference side of the power-supplying resonator 22 and the power-receiving resonator 32) . In this case, the magnetic field detector 11 is disposed in the space on the outer circumference side of the power-supplying resonator 22, where the magnetic field space G2 is formed.

Although the above descriptions have been provided with regard to the characteristic parts so as to understand the present invention more easily, the invention is not limited to the embodiments and the examples as described above and can be applied to the other embodiments and examples, and the applicable scope should be construed as broadly as possible. Furthermore, the terms and phraseology used in the specification have been used to correctly illustrate the invention, not to limit it. In addition, it will be understood by those skilled in the art that the other structures, systems, methods and the like included in the spirit of the present invention can be easily derived from the spirit of the invention described in the specification. Accordingly, it should be considered that the present invention covers equivalent structures thereof without departing from the spirit and scope of the invention as defined in the following claims. In addition, it is required to sufficiently refer to the documents that have been already disclosed, so as to fully understand the objects and effects of the present invention.

Reference Signs List

| | |
|---|---|
| 1: | Wireless Power Transmission Apparatus |
| 2: | Power-Supplying Module |
| 3: | Power-Receiving Module |
| 4: | Determination Control Device |
| 5: | Power Source Circuit |
| 6: | Power Source |
| 7: | Stabilizer Circuit |
| 8: | Charging Circuit |
| 9: | Rechargeable Battery |
| 10: | Power-Supplied Device |
| 11: | Magnetic Field Detector |
| 12: | Reporting Device |
| 21: | Power-Supplying Coil |
| 22: | Power-Supplying Resonator |
| 31: | Power-Receiving Coil |
| 32: | Power-Receiving Resonator |
| 101: | Charger |
| 102: | Wireless Headset |
| G1, G2: | Magnetic Field Space |

**Claims**

1. A wireless power transmission apparatus comprising:

   a power-supplying module configured to supply power to a power-receiving module by means of a resonance phenomenon which is established between the power-supplying module and the power-receiving module so that a magnetic field space having a lower magnetic field strength than that of nearby portions is formed;
   a magnetic field detector which is disposed at a position where the magnetic field space is formed and which is configured to detect the magnetic field strength; and
   a determination control device configured to determine whether there is an anomaly in power supply to the power-receiving module based on a value of the magnetic field strength detected by the magnetic field detector.

2. The wireless power transmission apparatus according to claim 1, wherein the determination control device is configured to stop power supply to the power-supplying module when determining that there is an anomaly in the power supply.

3. The wireless power transmission apparatus according to claim 1, further comprising a reporting device configured to give a report to an outside, wherein,
   when the determination control device determines that there is an anomaly in the power supply, the determination control device controls the reporting device to report the anomaly in the power supply.

4. The wireless power transmission apparatus according to claim 1, wherein:

   the power-supplying module and the power-receiving module respectively include at least a power-supplying resonator and a power-receiving resonator which resonate with each other at a predetermined resonance frequency; and

a power-source frequency of a power source is set to a frequency higher than the resonance frequency so that current in the power-supplying resonator and current in the power-receiving resonator flow in directions opposite to each other during power supply by means of the resonance phenomenon from the power-supplying resonator to the power-receiving resonator.

5. The wireless power transmission apparatus according to claim 1, wherein:

the power-supplying module and the power-receiving module respectively include at least a power-supplying resonator and a power-receiving resonator which resonate with each other at a predetermined resonance frequency; and

a power-source frequency of a power source is set to a frequency lower than the resonance frequency so that current in the power-supplying resonator and current in the power-receiving resonator flow in a same direction during power supply by means of the resonance phenomenon from the power-supplying resonator to the power-receiving resonator.

6. The wireless power transmission apparatus according to claim 1, wherein the magnetic field detector is a Hall-effect magnetic sensor.

7. The wireless power transmission apparatus according to claim 1, wherein the magnetic field detector is a coil.

8. The wireless power transmission apparatus according to claim 4, wherein:

the power-supplying resonator includes a coil; and

the magnetic field detector is disposed between a central axis of the coil and an inner circumferential surface of the coil, and closer to the inner circumferential surface of the coil rather than the central axis of the coil.

9. The wireless power transmission apparatus according to claim 8, wherein the magnetic field detector is disposed at a position along the inner circumferential surface of the coil.

10. The wireless power transmission apparatus according to claim 4, wherein:

each of the power-supplying resonator and the power-receiving resonator includes a coil; and

the magnetic field detector is disposed on an inner circumference side of the coil of power-supplying resonator, and closer to a facing portion of the coil of the power- supplying resonator which faces the coil of the power-receiving resonator than the other portion of the coil of the power-supplying resonator which does not face the coil of the power-receiving resonator.

11. The wireless power transmission apparatus according to claim 10, wherein the magnetic field detector is disposed at a position on a plane defined by the facing portion of the coil of the power-supplying resonator which faces the coil of the power-receiving resonator.

12. The wireless power transmission apparatus according to claim 4, wherein:

the power-supplying resonator includes a coil;

the magnetic field detector is a Hall-effect magnetic sensor configured to detect the magnetic field strength by using Hall effect to a thin plate-like semiconductor included therein; and

the Hall-effect magnetic sensor is disposed so that the thin plate-like semiconductor is oriented orthogonal to a direction of the central axis of the coil of the power-supplying resonator, on an inner circumference side of the coil of the power-supplying resonator.

FIG.1

FIG2.

MAGNETIC FIELD DETECTOR 11

MAGNETIC FIELD SPACE G1

MAGNETIC FIELD

POWER SOURCE

POWER SOURCE CIRCUIT

6

5

DETECTION SIGNAL

21    22

32    31

DETERMINATION CONTROL DEVICE

4

REPORTING DEVICE

12

STABILIZER CIRCUIT

7

CHARGING CIRCUIT

8

10

SECONDARY BATTERY

9

FIG.3

# FIG.4

(GRAPH OF TRANSMISSION CHARACTERISTIC "S21"
BETWEEN RESONATORS HAVING TWO PEAKS)

TRANSMISSION CHARACTERISTIC "S21"
BETWEEN POWER-SUPPLYING RESONATOR
AND POWER-RECEIVING RESONATOR

FIG.5

MEASUREMENT OF TRANSMISSION CHARACTERISTIC "S21" BETWEEN POWER-SUPPLYING RESONATOR 22 AND POWER-RECEIVING RESONATOR 32

FIG.6

FIG.7

# FIG.8

FIG.9

101

2

POWER-SUPPLYING
MODULE

MAGNETIC FIELD

21        22

FIG.10

101

2

POWER-SUPPLYING
MODULE

METAL FOREIGN
OBJECT

MAGNETIC FIELD

21        22

FIG.11 (NORMAL CHARGING STATE)

MAGNETIC FIELD
SPACE G1

MAGNETIC FIELD

HALL-EFFECT
MAGNETIC SENSOR 11A

POWER
SOURCE

POWER SOURCE
CIRCUIT

6

5

101

2

21   22

d23

32   31

3

102

OSCILLOSCOPE

STABILIZER
CIRCUIT                7

CHARGING
CIRCUIT                8        10

SECONDARY
BATTERY                9

# FIG.12

(STANDBY STATE)

MAGNETIC
FIELD

101

2

HALL-EFFECT
MAGNETIC SENSOR 11A

| POWER SOURCE | | POWER SOURCE CIRCUIT |
|---|---|---|

6

5

21

22

OSCILLOSCOPE

FIG.13

(ABNORMAL STATE)

101

2

MAGNETIC
FIELD

HALL-EFFECT
MAGNETIC SENSOR 11A

POWER
SOURCE

POWER SOURCE
CIRCUIT

METAL
FOREIGN
OBJECT

d23

6

5

21

22

OSCILLOSCOPE

FIG.14

STANDBY STATE

ABNORMAL STATE

NORMAL CHARGING STATE
(FORMATION OF MAGNETIC
FIELD SPACE G1)

5V

2.5V

Vp-p

0V

FIG.15

(MEASUREMENT EXPERIMENT 1)

|                              |                  |      | ABNORMAL STATE            |                            |                          |                           |                             |
|------------------------------|------------------|------|---------------------------|----------------------------|--------------------------|---------------------------|-----------------------------|
| HALL-EFFECT MAGNETIC SENSOR  | STANDBY STATE    | d23  | COPPER (5 mm PIECE)       | ALUMINUM (5 mm PIECE)      | COPPER (10mm PIECE)      | ALUMINUM (10mm PIECE)     | NORMAL CHARGING STATE       |
| DETECTION VOLTAGE p–p[mV]    | 94.6             | 3mm  | 92.7                      | 92.1                       | 89.0                     | 89.2                      | 83.5                        |
| DETECTION VOLTAGE p–p[mV]    | 94.6             | 2mm  | 92.3                      | 92.5                       | 86.1                     | 86.5                      | 81.3                        |

FIG.16

FIG.17

(MEASUREMENT EXPERIMENT 2)

ABNORMAL STATE

| MAGNETISM DETECTING COIL φ5mm | STANDBY STATE | d23 | COPPER (5 mm PIECE) | ALUMINUM (5 mm PIECE) | COPPER (10mm PIECE) | ALUMINUM (10mm PIECE) | NORMAL CHARGING STATE |
|---|---|---|---|---|---|---|---|
| DETECTION VOLTAGE p-p[mV] | 2.74 | 3mm | 2.62 | 2.62 | 2.36 | 2.36 | 1.86 |
| DETECTION VOLTAGE p-p[mV] | 2.74 | 2mm | 2.52 | 2.52 | 2.04 | 2.06 | 1.72 |

FIG.18

```
        ( POWER-SUPPLY OPERATION FLOW )
                        │
                        ▼
              ┌──────────────────┐      S1
              │   BOOT PROCESS   │─────
              └──────────────────┘
                        │
   S2                   ▼
     ╲     ╱────────────────────────────╲      NO
      ╲───┤   HAS PREDETERMINED          ├─────
          │   PERIOD OF TIME ELAPSED ?   │
           ╲────────────────────────────╱
                        │ YES
                        ▼
              ┌──────────────────────────┐    S3
              │ TRANSMIT DETECTION SIGNAL │───
              └──────────────────────────┘
   S4                   │
     ╲                  ▼
  ┌──────────────────────────────────────────────────────────┐
  │ MEASURE DETECTION VOLTAGE OF HALL-EFFECT MAGNETIC SENSOR  │
  └──────────────────────────────────────────────────────────┘
                        │
                        ▼             S5
          ╱────────────────────────────╲
   YES   │   DOES DETECTION             │
  ───────┤   VOLTAGE FALL WITHIN MAGNETIC│
         │   FIELD STRENGTH RANGE FOR    │
         │   STANDBY STATE?              │
          ╲────────────────────────────╱
                        │ NO
                        ▼             S8
          ╱────────────────────────────╲
         │   DOES DETECTION             │  YES
         │   VOLTAGE FALL WITHIN MAGNETIC├──────
         │   FIELD STRENGTH RANGE FOR NORMAL│
         │   CHARGING STATE?            │
          ╲────────────────────────────╱
                        │ NO
   S6          S11      ▼                          S9
    ╲           ╲                                   ╲
┌───────────┐  ┌───────────┐              ┌─────────────┐
│ DETERMINE │  │ DETERMINE │              │ DETERMINE   │
│ APPARATUS │  │ APPARATUS │              │ APPARATUS IS│
│ IS IN     │  │ IS IN     │              │ IN NORMAL   │
│ STANDBY   │  │ ABNORMAL  │              │ CHARGING    │
│ STATE     │  │ STATE     │              │ STATE       │
└───────────┘  └───────────┘              └─────────────┘
                     │                           │
                     ▼                           │
              ┌──────────────┐                   │
              │  REPORTING   │                   │
              │  PROCESS     │                   │
              └──────────────┘  S12              │
   S7               │                         S10│
    ╲               ▼                            ▼
┌───────────┐                          ┌─────────────┐
│ TURN OFF  │                          │ TURN ON     │
│ POWER     │                          │ POWER       │
│ SUPPLY TO │                          │ SUPPLY TO   │
│ POWER-    │                          │ POWER-      │
│ SUPPLYING │                          │ SUPPLYING   │
│ MODULE    │                          │ MODULE      │
└───────────┘                          └─────────────┘
```

# FIG.19

## (STANDBY STATE)

FACING SIDE PORTION 22A

COIL CENTRAL AXIS DIRECTION

22

3.5mm

3.5mm

3mm

10mm

h(mm)

10

5

3

0

-2

21A

11A

21

23

4mm

3mm

1.5mm

4mm

FIG.20

(NORMAL CHARGING STATE)

h(mm)

31
33
32

22

3mm

3.5mm

3.5mm

3mm

10mm

10

5
3

0

−2

COIL CENTRAL
AXIS DIRECTION

11A

21

23

FIG.21

(ABNORMAL STATE)

FIG.22

| A: HALL-EFFECT MAGNETIC SENSOR IS DISPOSED AT POSITION ALONG COIL CENTRAL AXIS (CENTER) | B: HALL-EFFECT MAGNETIC SENSOR IS DISPOSED AT POSITION BETWEEN COIL CENTRAL AXIS AND COIL INNER CIRCUMFERENTIAL SURFACE (MIDDLE) | C: HALL-EFFECT MAGNETIC SENSOR IS DISPOSED AT POSITION ALONG COIL INNER CIRCUMFERENTIAL SURFACE OF POWER-SUPPLYING RESONATOR (INNER SURFACE SIDE) |

2.5mm

11A — 22

— 23

COIL CENTRAL AXIS —

11A — 22

— 23

COIL CENTRAL AXIS —

11A — 22

— 23

COIL CENTRAL AXIS —

FIG.23

| A: HALL-EFFECT MAGNETIC SENSOR IS DISPOSED IN UPRIGHT ORIENTATION | B: HALL-EFFECT MAGNETIC SENSOR IS DISPOSED IN FLAT ORIENTATION |

22

11A

23

COIL CENTRAL
AXIS

22

11A

23

COIL CENTRAL
AXIS

# FIG.24

**A: HALL-EFFECT MAGNETIC SENSOR IS MOVED ALONG COIL CENTRAL AXIS**

**C: HALL-EFFECT MAGNETIC SENSOR IS MOVED ALONG COIL INNER CIRCUMFERENTIAL SURFACE OF POWER-SUPPLYING RESONATOR**

## FIG.25

| h | CENTER | MIDDLE | INNER SURFACE SIDE |
|---|---|---|---|
| 14 | 44 | 52 | 54 |
| 13 | 50 | 60 | 64 |
| 12 | 54 | 62 | 74 |
| 11 | 58 | 66 | 94 |
| 10 | 54 | 62 | 86 |
| 9 | 54 | 56 | 70 |
| 8 | 44 | 52 | 66 |
| 7 | 42 | 48 | 60 |
| 6 | 40 | 42 | 50 |
| 5 | 34 | 36 | 44 |
| 4 | 32 | 34 | 40 |
| 3 | 32 | 34 | 36 |
| 2 | 30 | 32 | 34 |
| 1 | 30 | 30 | 34 |
| 0 | 26 | 28 | 30 |
| -1 | 26 | 26 | 28 |
| -2 | 24 | 26 | 26 |

FIG.26

EP 3 096 436 A1

FIG.27

45

## INTERNATIONAL SEARCH REPORT

| International application No. |
|---|
| PCT/JP2015/050141 |

**A. CLASSIFICATION OF SUBJECT MATTER**
*H02J17/00*(2006.01)i, *H02J7/00*(2006.01)i

According to International Patent Classification (IPC) or to both national classification and IPC

**B. FIELDS SEARCHED**

Minimum documentation searched (classification system followed by classification symbols)
H02J17/00, H02J7/00

Documentation searched other than minimum documentation to the extent that such documents are included in the fields searched
Jitsuyo Shinan Koho           1922–1996   Jitsuyo Shinan Toroku Koho   1996–2015
Kokai Jitsuyo Shinan Koho   1971–2015   Toroku Jitsuyo Shinan Koho   1994–2015

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2013-192391 A  (Sony Corp.),<br>26 September 2013 (26.09.2013),<br>entire text; all drawings<br>& US 2013/0241300 A1    & CN 103308949 A | 1–12 |
| Y | JP 2013-240263 A  (Nitto Denko Corp.),<br>28 November 2013 (28.11.2013),<br>entire text; all drawings<br>& EP 2765682 A1          & WO 2014/087685 A1<br>& CN 103988397 A        & TW 201424184 A | 1–12 |
| Y | JP 2012-249401 A  (Nissan Motor Co., Ltd.),<br>13 December 2012 (13.12.2012),<br>entire text; all drawings<br>& US 2013/0169062 A1    & EP 2717431 A1<br>& WO 2012/165244 A1    & CN 103098344 A<br>& MX 2013002741 A | 1–12 |

| ☒   Further documents are listed in the continuation of Box C. | ☐   See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered    to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 09 February 2015 (09.02.15) | 24 February 2015 (24.02.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

| International application No. |
| --- |
| PCT/JP2015/050141 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 2012-504931 A (Access Business Group International L.L.C.), 23 February 2012 (23.02.2012), paragraphs [0143], [0144] & US 2010/0084918 A1 & WO 2010/040015 A2 & AU 2009298384 A & CA 2739071 A & KR 10-2011-0065552 A & TW 201034334 A & CN 102239619 A & RU 2011116999 A | 6,12 |
| A | JP 2012-075200 A (Toshiba Corp.), 12 April 2012 (12.04.2012), entire text; all drawings (Family: none) | 1-12 |
| A | WO 2013/179394 A1 (Pioneer Corp.), 05 December 2013 (05.12.2013), paragraphs [0046] to [0049]; fig. 3 (Family: none) | 1-12 |

Form PCT/ISA/210 (continuation of second sheet) (July 2009)

**EP 3 096 436 A1**

## REFERENCES CITED IN THE DESCRIPTION

**Patent documents cited in the description**

- JP 4624768 B
- JP 2013239692 A
- JP 2013062895 A